# EUROPÄISCHE PATENTSCHRIFT

(11) **EP 2 524 329 B1**
(45) Veröffentlichungstag und Bekanntmachung des Hinweises auf die Patenterteilung: **30.01.2019**
(21) Anmeldenummer: 10796021.3
(22) Anmeldetag: 17.12.2010
(51) Int. Cl.: G06F 17/50, G01B 21/04, G01B 11/03, B64F 5/00, B64C 1/00

(54) **ANORDNUNG UND VERFAHREN ZUR VERIFIKATION EINES REALEN MODELLS UNTER VERWENDUNG EINES VIRTUELLEN MODELLS SOWIE VERWENDUNG IM FLUGZEUGBAU**
ASSEMBLY AND METHOD FOR VERIFYING A REAL MODEL USING A VIRTUAL MODEL AND USE IN AIRCRAFT CONSTRUCTION
AGENCEMENT ET PROCÉDÉ POUR VÉRIFIER UN MODÈLE RÉEL EN UTILISANT UN MODÈLE VIRTUEL ET UTILISATION ASSOCIÉE DANS LA CONSTRUCTION AÉRONAUTIQUE

(30) Priorität: 18.12.2009 DE 102009058802
(43) Veröffentlichungstag der Anmeldung: 21.11.2012
(73) Patentinhaber: Airbus Operations GmbH, 21129 Hamburg (DE)
(72) Erfinder: BECKER, Benjamin, 80469 München (DE); SCHMIDT, Holger, 81543 München (DE); CALIS, Ilke Öncü, 21077 Hamburg (DE)
(74) Vertreter: LKGLOBAL Lorenz & Kopf PartG mbB Patentanwälte
(86) Internationale Anmeldenummer: PCT/EP2010/070155
(87) Internationale Veröffentlichungsnummer: WO 2011/073428

(56) Entgegenhaltungen:
- BENJAMIN BECKER ET AL: "Utilizing RFIDs for Location Aware Computing", 23. Juni 2008 (2008-06-23), UBIQUITOUS INTELLIGENCE AND COMPUTING; [LECTURE NOTES IN COMPUTER SCIENCE], SPRINGER BERLIN HEIDELBERG, BERLIN, HEIDELBERG, PAGE(S) 216 - 228, XP019090228, ISBN: 978-3-540-69292-8 * die gesamte Druckschrift, insbesondere Seite 219, Zeilen 17-20, Abb. 7, Seite 226, Zeilen 23-25 *
- WEBEL S ET AL: "Identifying differences between CAD and physical mock-ups using AR", MIXED AND AUGMENTED REALITY, 2007. ISMAR 2007. 6TH IEEE AND ACM INTERNATIONAL SYMPOSIUM ON, IEEE, PISCATAWAY, NJ, USA, 13. November 2007 (2007-11-13), Seiten 281-282, XP031269916, ISBN: 978-1-4244-1749-0

## Beschreibung

Die vorliegende Erfindung betrifft eine Mixed Reality Anwendung. Besonders betrifft die vorliegende Erfindung eine Anordnung zur kombinierten Darstellung eines realen und eines virtuellen Modells, ein Verfahren zur Simulation eines virtuellen Modells im Kontext eines realen Modells sowie die Verwendung einer erfindungsgemäßen Anordnung für ein Transportmittel, insbesondere für ein Flugzeug. Insbesondere betrifft die vorliegende Erfindung die Absicherung einer simultan real und virtuell durchgeführten Produktentwicklung auf Basis vereinheitlichter Werkzeuge. Auch betrifft die vorliegende Erfindung eine Anordnung und ein Verfahren zur Verifikation eines realen Modells unter Verwendung eines virtuellen Modells sowie deren Verwendung im Flugzeugbau.

Im Rahmen der Planung bzw. des Erstellens eines Vorentwurfs und letztendlich der Umsetzung eines neuen Produktes mögen reale Referenzmodelle, somit eine reale physische Abbildung bzw. ein physisch erstelltes neues Produkt, aber auch eine Umgebung, in welcher das Produkt später eingesetzt werden soll, zur Absicherung eines virtuellen Produktes entlang des vollständigen Produktlebenszyklus in Bezug auf Entwicklung, Fertigung und Wartung, verwendet werden. So mag beispielsweise im Falle einer Neuentwicklung eines Flugzeugpassagiersitzes ein physisches Referenzmodell eines per CAD-Anwendung erstellten virtuellen Sitzmodells angefertigt werden. Andererseits mag beispielsweise zumindest ein Ausschnitt einer Flugzeugkabine zum Überprüfen einer möglichen Integrierbarkeit bzw. Bedienbarkeit bereitgestellt werden. Aufgrund fehlender Produktreife, beispielsweise in einem frühen Planungsstadium eines neuen Produktes, mögen jedoch Anpassungen sowie Verbesserungen am realen Modell notwendig sein, welche letztendlich zu signifikanten Unterschieden zwischen einzelnen Modellen bzw. Teilmodellen, sowohl real als auch virtuell, führen mögen.

Denkbar mag auch die Fertigung und Produktion des Produktes sein. Im Falle eines Flugzeuges mag das Customizing z.B. über eine Sammlung von Modifikationen an einem Standardflieger verwaltet werden - was garantiert werden kann und muss. Die so entstehenden Flugzeuge müssen für die Zulassung mit dem Digital Mock-Up (DMU) in hohem Maße übereinstimmen. Der Einsatzbereich mag sich somit über die Produktentwicklung hinaus in die Fertigung, Qualitätssicherung und Zertifizierung erstrecken.

Auch mögen, bedingt durch eine hohe technische Komplexität bzw. Variabilität eines zu erstellenden Produktes, bereits im Stadium des virtuellen Entwurfs, beispielsweise in einer computergestützten Planungsphase, Abweichungen zwischen einzelnen Teilsystemen auftreten. Im Falle einer Flugzeugentwicklung mögen derartige Teilsysteme beispielsweise Flugzeugsysteme, Flugzeugstruktur, Flugzeugkabine bzw. Cockpit betreffen. Insbesondere die Verkabelung und die entsprechenden Halterungssysteme, mögen bei einem Flugzeug häufig problematisch sein, da diese sich durch Customization am stärksten ändern mögen. Eine prototypische Konfiguration eines Referenzmodells mag somit als Nachbau erstellt werden und mag hierdurch eine Abschätzung zwischen alternativen Produktkonfigurationen ermöglichen.

Ein protokollierter Abgleich zwischen einem realen und einem virtuellen Modell mag insbesondere aufgrund der meist räumlichen und physikalischen Trennung von Informationen zwischen realem und virtuellem Modell erschwert sein.

Es mag somit die Notwendigkeit gesehen werden, einen verbesserten Abgleich zwischen einem realen und einem virtuellen Modell bereitzustellen.

Die Druckschrift S. Webel et al. "Identifying differences between CAD and physical mock-ups using AR", Tagungsband des 6th IEEE and ACM International Symposium on Mixed and Augmented Reality, 2007, Seiten 281-281 beschreibt eine Anordnung, die ein reales und ein virtuelles Modell aufweist. Das reale Modell wird durch mindestens zwei Kameras aufgenommen und mit dem CAD Modell gemeinsam abgebildet, wobei die beiden Abbildungen überlagert werden. Eine Lösung mag die vorliegende Erfindung angeben, welche insbesondere eine verbesserte Schnittstelle zwischen einem realen Modell und einem virtuellen Modell bereitstellen mag. Zudem mögen sich in einer Produktentwicklung eine Vielzahl von räumlich zuordenbaren Informationen direkt vor Ort abrufen lassen.

Eine derartige Lösung wird durch eine Anordnung zur kombinierten Darstellung eines realen und eines virtuellen Modells, ein Verfahren zur Simulation eines virtuellen Modells im Kontext eines realen Modells sowie mit der Verwendung einer Anordnung zur kombinierten Darstellung eines realen und eines virtuellen Modells gemäß der vorliegenden Erfindung für ein Transportmittel, insbesondere für ein Flugzeug, gemäß der unabhängigen Patentansprüche angezeigt.

Bevorzugte Ausgestaltungen ergeben sich aus den abhängigen Ansprüchen.
Im Weiteren sind auch erfindungsgemäße Aspekte aufgezeit.

Die vorliegende Erfindung präsentiert eine nichtstatische, interaktive Anwendung im Bereich der Augmented Reality bzw. Mixed Reality. Hierbei ist es insbesondere von Vorteil, eine Visualisierungsvorrichtung zu verwenden, beispielsweise einen mobilen bzw. portablen Computer, PDA oder Vergleichbares, welcher in der Lage ist, auch komplexe Inhalte zu visualisieren bzw. darzustellen, beispielsweise als zweidimensionale, dreidimensionale oder quasi dreidimensionale Abbildung einer Grafik. Hierbei ist ein Vermischen bzw. Überlagern des virtuellen Modells mit einem realen Modell, somit das Einbinden des virtuellen Modells in den Kontext eines realen Modells vorteilhaft. Mixed und Augmented Reality mögen insbesondere entlang eines Kontinuums dargestellt werden, welches einen fließenden Übergang zwischen Realität und Virtualität beschreibt.

Ein derartiges Einblenden, beispielsweise eines virtuellen Produktes, somit eines Produktes, welches zu einem Zeitpunkt möglicherweise ausschließlich als eine computergenerierte Simulation des geplanten Produktes vorliegt, mag z.B. in den Kontext eines realen Modells, beispielsweise ein unter Verwendung einer Informationsaufnahmevorrichtung, wie einer Foto- bzw. Videokamera, aufgenommenes Bild des realen Modells, vorgenommen werden.

Weiterhin mag ein Überlagern von realem und virtuellem Modell beispielsweise unter Verwendung eines head-mounted Displays erfolgen, welches z.B. die Inhalte des virtuellen Modells direkt, angepasst an ein betrachtetes reales Modell, in das Auge eines Betrachters einzublenden vermag.

Ein Abgleich von einem Planungszustand, beispielsweise eines virtuellen Modells, mit dem Ist-Zustand, beispielsweise eines realen Modells, mag sich in beide Richtungen vorteilhaft erweisen. Einerseits mag ein reales Modell anhand eines virtuellen Modells verifiziert bzw. angepasst werden, andererseits mögen möglicherweise direkt im realen Modell vorgenommene Änderungen bzw. Parameter ermittelt und aufgezeichnet werden und direkt in das virtuelle Modell transferiert werden. Mögliche Werkzeuge bzw. Elemente zur Aufnahme von Messwerten bzw. Parametern des realen Modells mögen diese referenziert bzw. definiert an das virtuelle Modell weitergeben und dieses somit direkt beeinflussen bzw. abändern oder anpassen.

Mögliche Elemente sind hierbei Messtaster für eine Positionsbestimmung, Farbmessgeräte, Helligkeitsmessgeräte. Weiterhin denkbar sind im Bereich von Datenhandschuh/Fingertracking und Full Body Tracking auch eine Überwachung von Arbeitsabläufen um diese entsprechend automatisch mit den geplanten Abläufen zu vergleichen. Des weiteren mag es denkbar sein auch reale Werkzeuge, z.B. Schraubenschlüssel etc. vom System erkennen zu lassen um die Arbeitsabläufe und verwendeten Werkzeuge entsprechend zu überwachen, z.B. für Training und Fehlererkennung in realen Bauprozessen. Messtaster mögen einem oder mehrere Knöpfe aufweisen um Aktionen auszulösen, eine Photokamera mag Verwendung finden um z.B. Bildinformation, insbesondere z.B. georeferenziert, in das virtuelle Modell zu übertragen. Die Kamera mag hierbei als real/virtuelles Werkzeug von der Positionsbestimmungsvorrichtung erkannt werden. Beim Auslösen der Kamera mag so zum Beispiel ein reales Photo sowie ein virtueller Screenshot mit den selben Kameraparametern, intrinsisch z.B. Fokus und Brennweite, extrinsisch Position und Orientierung aufgenommen werden, somit georeferenziert, um diese entsprechend später abgleichen zu können.

Motion Capturing Anzüge mögen verwendet werden um Personen und deren Bewegungen sowie die Interaktion mit dem Produkt in das virtuelle Modell zu übertragen. Dies ist analog auch umgekehrt denkbar, z.B. eine rein virtuelle Aufnahme bzw. Computergenerierung mit Abspielen in der Mixed Reality Umgebung, ein 3D Scanning Verfahren mag mit einem Positionsbestimmungselement kombiniert werden, um den visuellen Abgleich von 3D Daten direkt nachvollziehen zu können. Ein positionsabhängiges Lesegerät, z.B. für Barcodes oder RFID, mag kontextsensitive Produktdaten aus anderen Quellen ermitteln. Ein identisches Werkzeug im realen und virtuellen Modell erlaub das identische Selektieren und Auswerten von Meta Informationen sowohl in der virtuellen und realen Welt. Annotationswerkzeuge mögen in der virtuellen Welt Anmerkungen, z.B. Text, Ton oder Bild/Videoelemente zu setzen. Ein identisches Werkzeug, z.B. ein Lautsprechersystem oder ein Videoprojektionssystem, mag verwendet werden, um dies auch in der Realität zu ermöglichen. Dies mag z.B. die Vorbereitung von Fehlern/Aktionen für nachfolgende Arbeiten ermöglichen. Eine Integration von Werkzeugen im Allgemeinen mag verwendet werden, beispielsweise die Anbindung von z.B. Bohrwerkzeugen im realen und virtuellen Raum um die Untersuchung von Baubarkeiten zu ermöglichen. Die entsprechenden Instrumente bzw. Werkzeuge mögen hierbei mit identischer oder verbundener Funktion wie im realen Modell im virtuellen Modell implementiert werden,

Als ein applikationsbezogener Aspekt der vorliegenden Erfindung mag die virtuelle Abbildung realer Werkzeuge im Kontext des virtuellen Modells gesehen werden. Somit mag die Absicherung komplexer Produktkonfigurationen mit Hilfe einer Kombination von realem, ggf. validiertem Modell mit virtuellen Komponenten erfolgen. Hierbei mag ein Datenmodell Verwendung finden, welches es erlaubt, das virtuelle Produkt bzw. virtuelle Modell im direkten physikalischen Kontext eines realen Modells, beispielsweise unter Verwendung eines Computers zur Visualisierung des virtuellen Modells zu verwenden. Das reale Modell mag hierbei einerseits einem Nachbau des virtuellen Modells entsprechen, beispielsweise einen Prototypen des virtuellen Modells darstellen, oder aber mag beispielhaft einer Umgebung entsprechen, in welcher das virtuelle Modell als späteres reales Produkt verwendet werden soll.

Weiterhin ist eine dynamische Konfiguration des virtuellen Modells denkbar, beispielsweise auf Basis von in einem Produktdatenmanagementsystem vorgehaltenen, möglicherweise unterschiedlichen Konfigurationen eines virtuellen Modells bzw. des realen Nachbaus. So mögen sich z.B. unterschiedliche Realisierungen eines Produktes im Rahmen unterschiedlicher virtueller Modelle kurzfristig gezielt ändern bzw. anpassen und hierbei in den Kontext des realen Modells durch überlagernde Abbildung einbinden lassen. Eine typische Aufgabe der Produktvor-entwicklung sind auch Fertigungstoleranzen. Hierbei muss überprüft werden ob bei der definierten Toleranz der Fertigung die Funktion eingeschränkt ist. Beispiele sind Jammed Section / Rumpftonnen die entsprechend 'verzogen' sein mögen und damit die Einbauten aller anderen Systeme betreffen. Insbesondere auch Flugzeugflügel mögen kritisch sein, da diese sich in definierten Bereichen im Flug verwinden / biegen. Der zu untersuchende Lösungsraum ist also nicht nur durch die Produktkonfiguration definiert.

Somit mögen sich Abbildungen von Produktvarianten bzw. Modellvarianten und deren möglicher Konfigurationen in Verbindung mit dem realen Modell einer Teilkonfiguration, somit einer Teilanpassung, zur Absicherung alternativer Varianten abbilden lassen und hierbei einen Vergleich zu existierenden, bereits abgesicherten Konfigurationen herstellen. Freiheitsgrade werden bei der Produktentwicklung definiert werden um verschiedene Einsatzszenarien und damit Kundengruppen zu erreichen. Da Produkte einerseits modularer werden, andererseits aber auch der Grad an Personalisierung bzw. Customization nicht nur in der Luft- und Raumfahrt kontinuierlich zunimmt, muss geklärt sein welche Produktkonfiguration und welche Produktoptionen entsprechend zusammen gewählt werden können. Modularisierung beim Flugzeugbau sollte möglichst geringen Einfluss auf die Leistungsdaten, insbesondere das Gewicht, eines Flugzeuges haben. Somit mag nicht alles einfach überdimensionierbar sein um die Optionsvielfalt abzudecken.

Produktinformationen von Modellen mögen sich aus verschiedenen Datenbanksystemen in den Kontext des realen Referenzmodells einbinden lassen, beispielsweise Product Data Management System (PDM), Product Lifecycle Management System (PLM) und SAP.

Durch einen Vergleich, beispielsweise Abmessung bzw. Parameterermittlung, mögen sich Produktinformationen protokollieren, annotieren bzw. verändern und diese Änderungen in das virtuelle Modell bzw. in dessen zugehörige Datenbank zurückführen lassen.

Unterschiedliche Messverfahren zur Verifikation bzw. Festlegung einzelner Produktparameter im virtuellen sowie im realen Referenzmodell mögen Verwendung finden, z.B. Position, Bemaßung, Farbton, Helligkeit sowie Funktion eines Produktes bzw. Modells. So lassen sich unter Verwendung eines realen Messtasters sowie eines virtuellen Messtasters die Bemaßung von virtuellem bzw. realem Modell vergleichen, mögliche Abweichungen protokollieren und gegebenenfalls gleichzeitig für die interaktive Anpassung eines virtuellen Modells verwenden.

So mag ein realer Messtaster für visuellen Abgleich von Kenngrößen im realen bzw. virtuellen Modell verwendet werden. Somit mag ein einheitliches Werkzeug für das virtuelle sowie das reale Produkt, einmal im realen Modell als reales Werkzeug sowie im virtuellen Modell als virtuelles Werkzeug, verwendet werden. Somit mag es z.B. möglich sein mit dem selben Messtaster auf dem visuellen Endgerät ein virtuelles Objekt zu bemaßen.

Weiterhin mögen Unterschiede bzw. Deltas von Soll- und Ist-Wert zwischen dem realen Modell und dem virtuellen Modell angezeigt werden, beispielsweise Positions- oder Orientierungsdifferenzen, Größenunterschiede oder beispielsweise Helligkeits- oder Farbabweichungen. Die Kombination eines virtuellen und eines realen Messelementes, zum Beispiel eines Messtasters, mag einen numerischen Vergleich ermöglichen. Auch eine exakte Protokollierung von Abweichungen zwischen realem und virtuellem Modell zum Beispiel für eine Toleranzanalyse oder aber auch eine Zertifizierung sind realisierbar. Hierdurch ist bevorzugt eine interaktive Schnittstelle zwischen virtuellem Modell und realem Modell bereitgestellt.

Denkbar ist auch, beispielsweise den Farbton eines Teils eines realen Modells zu verwenden, um eine entsprechende Änderung des virtuellen Modells vorzunehmen. Somit ist eine integrierte Interaktion zwischen realem Modell sowie virtuellem Modell denkbar und realisierbar.

Weiterhin mag die Integration eines Menschen in eine reale bzw. virtuelle Produktentwicklung realisierbar sein. So mag sich eine ergonomische Absicherung eines virtuellen Produktes unter Verwendung eines virtuellen Menschmodells realisieren lassen. Andererseits mögen sich reale Referenzmodelle unter Verwendung realer Testpersonen ergonomisch absichern lassen, z.B. hinsichtlich Baubarkeit und für Training und Trainingskontrolle. Virtuelle Untersuchungsergebnisse lassen sich hierbei innerhalb eines realen Modells integrieren; ebenso ist die umgekehrte Integration von realen Untersuchungsergebnissen innerhalb eines virtuellen Modells denkbar.

Weiterhin mögen reale Prototypen unter Verwendung eines virtuellen Menschmodells überprüft bzw. verifiziert werden, andererseits mag ein virtuelles Modell bzw. Produkt einem Abbild einer realen Testperson überlagert werden, um hierbei das virtuelle Modell überprüfen zu können.

Insbesondere von Vorteil ist hierbei eine Positionsbestimmung in einem definierten Raum. Hierbei mag ein realer Raum, somit das reale Modell, mit einem realen Koordinatensystem versehen sein. Ein reales Koordinatensystem mag derart verstanden werden, wonach es möglich sein soll, jeden Gegenstand bzw. Punkt oder Raumpunkt im realen Modell eine definierte Koordinate bzw. Bezugsgröße zuordnen zu können.

Gleichfalls mag das virtuelle Modell ein virtuelles Koordinatensystem aufweisen, welches eine eindeutige Referenzierung von Elementen bzw. Raumpunkten im virtuellen Modell ermöglicht. Bevorzugt sind das reale Koordinatensystem und das virtuelle Koordinatensystem im Wesentlichen identisch, um eine einfache Überlagerung bzw. Umrechnung und Positionsvergleich zwischen realem Modell und virtuellem Modell zu ermöglichen.

Hierbei mag die Koordinatenbasis eines Trackingsystems auf ein Koordinatensystem des realen Modells kalibriert werden, um somit eine Basis einer hochgenauen Abbildung zu bilden. Eine Kalibrierung mag hierbei eine Kalibrierung bzw. Definition von Messpositionen im Falle von zuvor angesprochenen Messelementen bzw. Werkzeugen sowie die Kalibrierung von Visualisierungsvorrichtungen bzw. Darstellungsgeräten, welche eine Visualisierung des virtuellen Modells bzw. eine überlagerte Visualisierung von realem Modell sowie virtuellem Modell ermöglichen können, hinsichtlich ihres Sichtfensters, somit ihres Betrachtungswinkels bzw. Richtung im Raum umfassen. Eine derartige Visualisierungsvorrichtung mag somit als "Fenster" in das virtuelle Modell unter Verwendung der Referenzbasis des realen Modells verstanden werden.

Weiterhin ist eine Implementierung eines virtuellen Werkzeuges im virtuellen Modell denkbar sein, beispielsweise um direkte Vergleiche zwischen Messwerten von realem Modell und virtuellem Modell und somit eine Aussage über mögliche Unterschiede unter Verwendung vergleichbarer Bedienmodalitäten bereitzustellen.

So mag z.B. eine Positionserfassung mit Hilfe eines Messtasters im realen Raum erfolgen. Ein derartiger Messtaster mag eine in Bezug auf das Koordinatensystem des realen Raumes referenzierte, punktförmige Spitze aufweisen. Somit mag eine Position beispielsweise durch einfaches Aufbringen der referenzierten Spitze des Messtasters auf den zu vermessenden Punkt bzw. die Position erfolgen. Weiterhin mag ein Farbmessgerät bzw. Spektralmessgerät oder aber auch ein Helligkeitsmessgerät für Lux bzw. Lumen denkbar sein. Sämtliche Werkzeuge sind hierbei bevorzugt portabel, somit tragbar bzw. bedienbar durch bevorzugt eine Person ausgelegt. Auch mag ein Full Body Tracking oder aber ein Fingertracking vorgenommen werden, um Bewegungen bzw. Interaktionen im realen Raum erfassen und diese beispielsweise in das virtuelle Modell übertragen zu können. Bevorzugt ist hierbei einerseits die Bewegung selbst detektierbar als auch deren Anordnung und Ausrichtung im Raum. Weiterhin sind Kombinationswerkzeuge für eine bestimmte Funktion bezüglich eines Ablaufs oder Zustandes denkbar. Ein Messtaster mit Eingabeelement ist ein Beispiel eines Kombinationswerkzeuges.

Auch die Eingabe von Daten, beispielsweise Annotationen, Statusberichten bzw. Fotos ist denkbar.

Die realen Werkzeuge mögen, wie zuvor dargelegt, ebenfalls ein virtuelles Pendant im virtuellen Modell aufweisen. So mag eine Positionserfassung über einen Selektionsstrahl bzw. PickRay oder per Messtaster möglich sein, welche gleichzeitig eine einfache Korrekturmöglichkeit von erfasster bzw. eingenommener Position bereitstellt. Weiterhin mögen Messwerte basierend auf einer selektierten Position erfasst bzw. bestimmt werden, beispielsweise für eine Farbwert- bzw. Helligkeitsermittlung. Abbildungen von Menschen bzw. virtuellen Testpersonen, insbesondere einer zugehörigen Bewegung in oder Interaktion mit der virtuellen Szene eines virtuellen Modells zur Steuerung von Produktfunktionen in Bezug auf Kinematik und Animation, somit Bewegungsablauf des Steuervorgangs, sind denkbar.

Für eine derartige Implementierung eines virtuellen Modells in einem realen Modell mag beispielsweise ein portabler Computer bzw. Display oder PDA verwendet werden, auf welchem zumindest die virtuellen Informationen bzw. das virtuelle Modell darstellbar sind, oder aber auf welchem eine gemeinsame Abbildung von realem Modell und überlagertem virtuellem Modell darstellbar ist. Verfahren und Produkte aus dem Bereich Wearable Computing mögen die Anpassung und Integration von Bild gebenden Technologien an den Menschen bzw. an ein virtuelles Modell ermöglichen. Weiterhin mag beispielsweise ein Head-mounted Display mit Durchsichtsfunktion verwendet werden, welches referenziert auf das Koordinatensystem von virtuellem Modell und/oder realem Modell eine Projektion von Informationen vor das Sichtfeld bzw. direkt in das Auge eines Betrachters ermöglicht.

Eine Informationsaufnahmevorrichtung, beispielsweise eine Kamera, bevorzugt direkt an der Bild gebenden Visualisierungsvorrichtung angeordnet, mag einerseits zur Erfassung von Bildinformationen für Dokumentationszwecke, andererseits für die Aufnahme des realen Modells zur Überlagerung mit dem virtuellen Modell verwendet werden. Hierbei mag auch eine 3D-Rekonstruktion denkbar sein. Diese mag kamerabasiert möglich sein, z.B. mittels Fotogrammetrie oder einer 3D-Time-Of-Flight-Kamera. Alternativ mag ein integrierter Laserscanner verwendet werden, dessen Position auch zeitsynchronisiert erfasst werden mag.

Zur Darstellung, Realisierung und/oder zum Abgleich zwischen realem Modell und virtuellem Modell mag beispielsweise eine Anbindung an ein Produktdatenmanagementsystem bzw. an ein Produktlebenszyklusmanagementsystem gegeben sein, welches ein automatisiertes oder manuelles Auslesen sowie Einpflegen von Daten ermöglicht. Somit ist eine Integration in eine Unternehmensinfrastruktur denkbar. Hierüber mag auch eine Nutzung von generischen Produktinformationen zur Zuordnung verschiedener Daten zu einzelnen im virtuellen und/oder realen Modell implementierten Produkten bzw. Produktteilen möglich sein.

Ein nach Möglichkeit vollständig definiertes virtuelles Produktmodell mag somit für einen Abgleich von virtuellem Modell und realem Modell optimiert abgebildet werden und angebunden sein. Eine Integrationsplattform mag die Verbindung unterschiedlicher Produktinformationen aus möglicherweise einzelnen, separaten, angebundenen Datenbanken ermöglichen. Konfigurationssysteme mögen weiterhin automatisiert ein virtuelles Modell sowie hierzu zu evaluierende Abwandlungen bzw. Erweiterungen generieren.

Eine entsprechende Überführung von realem Modell in virtuelles Modell mag weiterhin die Nutzung eines ergonomischen Menschmodells, beispielsweise Ramsis oder Jack, ermöglichen. Reale Bewegungsabläufe lassen sich unter Anbindung eines kalibrierten Motion Capturing Systems ins virtuelle Modell übertragen. In dem virtuellen Modell aufgenommene Bewegungsdaten mögen zur Analyse von Funktionen und ergonomischen Aspekten wie Erreichbarkeit von Gegenständen bzw. Belastungen analysiert und abgespielt werden. Eine Kombination von virtuellem Menschmodell und einem realen Menschen bzw. Benutzer mag einen fließenden Übergang einer ergonomischen Absicherung zwischen realem und virtuellem Modell ermöglichen. Applikationsspezifische und/oder werkzeugbasierte Auswertungsmöglichkeiten bezüglich erfasster Daten mögen somit bereitgestellt werden. Im Weiteren mag hierdurch die Übertragbarkeit von Ergebnissen, insbesondere Messergebnissen, zwischen realem und virtuellem Modell sichergestellt sein. Somit mag eine Qualitätskontrolle eines virtuell entwickelten Produktes in einem virtuellen Modell anhand eines physikalischen, realen Referenzmodells durchgeführt werden. Komplexe Produktkonfigurationen mögen sich durch eine Kombination von realem, möglicherweise bereits validiertem Modell sowie neuer, virtueller Komponenten absichern lassen. Weiterhin ist eine ortsbezogene Bereitstellung, Aktualisierung und Annotierung von Produkt bzw. Bauteilinformationen durch eine Verknüpfung von realem Kontext und virtuellem Modell möglich. Arbeitsvorgänge mögen anhand einer direkten Kombination von realen und virtuellen Untersuchungsergebnissen protokolliert werden. Ergebnisse, insbesondere Messergebnisse, lassen sich hierdurch einfach in das digitale, virtuelle Modell zurückführen. Somit wird eine Verifikation eines digitalen, virtuellen Modells anhand eines direkten Abgleichs des virtuellen Modells mit einem realen Modell sichergestellt.

Ein System bzw. eine Anordnung gemäß der vorliegenden Erfindung mag weiterhin z.B. im Bereich Training Anwendung finden. Beispielsweise über definierte Arbeitsanweisungen vorgegebene Arbeits- bzw. Bewegungsabläufe können protokolliert und im Vergleich zu den vorgegebenen Anweisungen bewertet werden.

Weiterhin mag mit einer Anordnung gemäß der vorliegenden Erfindung eine Baubarkeit bzw. Wartbarkeit eines Produktes evaluiert werden. So mögen Ein- bzw. Ausbauuntersuchungen bzw. Ergonomieuntersuchungen durchgeführt werden. Daten mögen auch gespeichert werden um zu einem späteren Zeitpunkt wiederverwendet/verglichen zu werden. Ein validierter Abgleich zwischen realem Modell und virtuellem Modell mag weiterhin Untersuchungen unterschiedlicher Produktausprägungen anhand eines Referenzmodells ermöglichen. Geplante Arbeits- bzw. Bewegungsabläufe mögen gleichfalls bewertbar sein. Ein Soll/Ist-Vergleich bzw. Sichtbarkeitsuntersuchungen eines vereinfachten realen Modells mit einem vollständig definierten, virtuellen Modell zur Absicherung zertifizierungsrelevanter Details wie beispielsweise Warnschilder und Beschriftungen mögen eine Zertifizierbarkeit gemäß FAA- bzw. JAA-Regularien ermöglichen bzw. zumindest erleichtern.

Die Konfigurierbarkeit eines Modells zum Beispiel gemäß eines Produktkatalogs, Color and Trim, Surface Check mag durch eine Integration des vollständigen Konfigurationsraumes, welcher unter Verwendung des virtuellen Modells in das reale Referenzmodell mit einer Standardkonfiguration eingeblendet werden mag, gegeben sein. In anderen Worten mögen beispielsweise für ein Objekt oder einen Teil eines Objektes verfügbare Farbkombinationen derart als virtuelles Modell in eine kombinierte Gesamtsicht eingeblendet werden, um beispielsweise in einem realen Modell eine zugehörige Fläche des Elementes, welche beispielsweise weiß gehalten ist, mit einer konfigurierbaren Farbe zu versehen.

Somit mag eine Absicherung unterschiedlichster Konfigurationseigenschaften möglich sein, wie beispielsweise Anordnung und resultierendes Raumgefühl, Farb- und Helligkeitswahrnehmung. Weiterhin mag die Bedienbarkeit eines Modells in Bezug auf Ergonomie, funktionale Absicherung und Lesbarkeit vorgenommen werden. Basisfunktionalitäten einzelner Produktgruppen mögen innerhalb des realen und/oder virtuellen Modells validiert werden, beispielsweise Funktionen wie "Tür öffnen", "Sitz verstellen" und "Hatrack beladen".

Um insbesondere eine Überlagerung eines realen Modells und eines virtuellen Modells zu ermöglichen, mag es notwendig erscheinen, das virtuelle Modell sowie das reale Modell in eine örtliche Relation zueinander zu setzen, insbesondere beide möglicherweise auf einer aufeinander angepasste Rauminformationsbasis bereitzustellen. Da das virtuelle Modell aufgrund von computerunterstützter Planung bzw. Erstellung im Regelfall bereits über ein eigenes Koordinaten- bzw. Bezugssystem verfügen mag, mag es bevorzugt sein, dieses virtuelle Koordinatensystem zu einem realen Modell bzw. dessen realem Koordinatensystem in Relation bzw. in Bezug zu setzen. Somit mag es einerseits notwendig sein, eine 3D-Positionsbestimmung im realen Modell bereitzustellen und eine dort bestimmte Position zur Ausrichtung des virtuellen Modells zu verwenden.

Um beispielsweise unter Verwendung einer Kamera ein Abbild des realen Modells aufzunehmen, um dieses mit einem virtuellen Teilmodell überlagern zu können, mag es notwendig sein, die Position und/oder Orientierung einer Visualisierungsvorrichtung, welche beispielsweise zur überlagerten Darstellung von realem und virtuellem Modell verwendet werden mag, im realen Modell bzw. im Raum eines realen Modells festzulegen. Hierbei mag ein erstes Positionsbestimmungselement, zum Beispiel eine Anordnung aus Markern, z.B. Infrarotmarker, welche passiv bestrahlt werden oder aktiv strahlen können, an der Visualisierungsvorrichtung definiert anbringbar sein. Jegliche Markertechnologie, die eine Detektierung mit einer geforderten Genauigkeit einer Raumposition bzw. - orientierung ermöglicht mag hierbei verwendet werden. Ein optisches System mag hierbei eine besonders präzise Alternative darstellen, jedoch mögen auch andere Technologien, z.B. Ultraschall, magnetische Technologien oder auch eine Kombinationen solcher Technologien zum Einsatz kommen. Eine Positionsbestimmungsvorrichtung, beispielsweise platziert im Raum des realen Modells, mag somit zunächst eine Position der Visualisierungsvorrichtung relativ zur Positionsbestimmungsvorrichtung feststellen. Die Positionsbestimmungsvorrichtung mag hierbei selbst die Position eines Positionsbestimmungselementes bzw. dessen Orientierung bestimmen oder aber mag Mittel bereitstellen, um einem Positionsbestimmungselement zu ermöglichen, seine Position, in absoluter oder relativer Art, zu bestimmen. Wenn nun die Relation im Raum, d.h. Position und/oder Orientierung, des Positionsbestimmungselementes und somit der Visualisierungsvorrichtung zur Positionsbestimmungsvorrichtung festgelegt ist, mag über ein weiteres Positionsbestimmungselement, welches in einer festgelegten Relation zum realen Modell steht, ein Bezug von Position und/oder Orientierung des realen Modells zur Positionsbestimmungsvorrichtung angegeben werden.

Dies mag z.B. durch Anbringen eines zweiten Positionsbestimmungselementes am realen Modell möglich sein. Hierbei mag es insbesondere bevorzugt sein, dass das reale Modell in sich kompakt und insbesondere unveränderlich ist, somit keine Freiheitsgrade aufweist, um einen möglicherweise nicht detektierbaren Versatz zwischen zweitem Positionsbestimmungselement und Positionsbestimmungsvorrichtung zu vermeiden. Weiterhin ist denkbar, an jedem beweglichen Element eines realen Modells ein individuelles Positionsbestimmungselement anzubringen, welche unabhängig voneinander detektierbar sein mögen, um die jeweilige Position und/oder Orientierung des Elementes des realen Modells gegenüber der Positionsbestimmungsvorrichtung festzulegen. Andererseits mag, vorausgesetzt, dass ein in sich kompaktes, nach Möglichkeit unveränderliches reales Modell in fester Relation zur Positionsbestimmungsvorrichtung anordenbar ist, es nicht notwendig sein, Elemente des realen Modells dauerhaft oder zumindest über längere Zeit mit Positionsbestimmungselementen zu versehen, vielmehr mag es ausreichend sein, definierte Punkte des realen Modells im Raum der Positionsbestimmungsvorrichtung anzuzeigen, um somit einen Bezug zwischen realem Modell und Positionsbestimmungsvorrichtung herzustellen. So mag es im Regelfall ausreichend sein, ein beliebiges Element im Raum unter Verwendung von drei eindeutigen Punkten, welche beispielsweise mit einem zweiten Positionsbestimmungselement an eine Positionsbestimmungsvorrichtung übermittelt werden, definiert im Raum festzulegen. Mehr als drei definierte Punkte mögen insbesondere die Genauigkeit und Robustheit einer Detektion im Raum erhöhen.

Als Beispiel sei eine Anwendung der Anordnung zur kombinierten Darstellung eines realen und eines virtuellen Modells gemäß der vorliegenden Erfindung in einem Flugzeug angezeigt. Das reale Modell besteht z.B. aus einer Passagiersitzgruppe, beispielsweise mit drei Sitzplätzen. Das virtuelle Modell besteht aus einer vergleichbaren Anordnung, welche beispielsweise definiert einfärbbar ist, um unterschiedliche Konfigurationsmöglichkeiten einer solchen Sitzgruppe aufzuzeigen.

Die Positionsbestimmungsvorrichtung wird nun im Raum derart aufgebaut, so dass ein physischer Raum, in welchem sich das reale Modell, somit die Sitzgruppe befindet, detektierbar abgedeckt ist. Um nun eine Relation zwischen realem Modell und Positionsbestimmungsvorrichtung herzustellen, mögen beispielsweise sechs definierte Punkte, beispielsweise Mittelpunkt jeder Rückenlehne sowie der Mittelpunkt jeder Sitzfläche angezeigt werden. Bevorzugt sind diese hochpräzise auf dem realen Modell angebracht, um eine einfache Bestimmung des Punktes zu ermöglichen.

Unter Verwendung eines zweiten Positionsbestimmungselementes werden diese Punkte der Positionsbestimmungsvorrichtung angezeigt und von dieser detektiert. Hierbei mag es irrelevant sein, inwieweit die Positionsbestimmungsvorrichtung überhaupt von der physischen Ausgestaltung des realen Modells Informationen erhält. Zum jetzigen Zeitpunkt mag es ausreichend sein, ausschließlich eine Relation zwischen Positionsbestimmungsvorrichtung und jedem der zu detektierenden Punkte im Raum anzuzeigen. Somit ist eine relative Position definiert zwischen dem realen Modell und der Positionsbestimmungsvorrichtung festgelegt.

Im Weiteren wird unter Verwendung einer Visualisierungsvorrichtung ein virtuelles Modell dargestellt. Die Visualisierungsvorrichtung weist ein erstes Positionsbestimmungselement auf, wodurch eine definierte Position und Orientierung der Visualisierungsvorrichtung in Bezug auf die Positionsbestimmungsvorrichtung detektierbar ist. Das virtuelle Modell mag nun ebenfalls die gleichen identischen Punkte, nun jedoch virtuell, aufweisen bzw. definiert haben, welche zuvor unter Verwendung des zweiten Positionsbestimmungselementes der Positionsbestimmungsvorrichtung angezeigt wurden. Somit ist einerseits eine Relation von realem Modell zu Positionsbestimmungsvorrichtung festgelegt als auch von Bestimmungsvorrichtung zum ersten Positionsbestimmungselement und somit zur Visualisierungsvorrichtung. Aufgrund der in der Visualisierungsvorrichtung bekannten Referenzpunkte mag nunmehr eine Überlagerung des realen Modells und des virtuellen Modells in der Visualisierungsvorrichtung erfolgen.

Eine Informationsaufnahmevorrichtung, beispielsweise eine Kamera, welche ebenfalls definiert an der Visualisierungsvorrichtung angebracht ist, und eine definierte Orientierung und einen Blickwinkel bzw. eine Brennweite aufweist, mag ein Abbild beispielsweise des realen Modells aufnehmen und auf der Visualisierungsvorrichtung darstellen. Aufgrund der referenzierten Relationen von virtuellem Modell und realem Modell mag nunmehr das Abbild des realen Modells vom virtuellen Modell zumindest teilweise überlagert werden. Beispielsweise mag somit ein weiß gefärbtes Modell einer realen Passagiersitzgelegenheit von einem anders gefärbten virtuellen Modell überlagert werden, so dass unter Verwendung der Visualisierungsvorrichtung ein Eindruck für einen Betrachter entsteht, welcher einem eingefärbten realen Modell, abgebildet auf der Visualisierungsvorrichtung, entspricht.

Aufgrund der Überlagerung von realem Modell und virtuellem Modell mag somit beispielsweise durch Änderung der Konfiguration des virtuellen Modells die Farbgestaltung der realen Sitzgelegenheit in der Abbildung der Visualisierungsvorrichtung verändert werden.

Virtuelles Modell und reales Modell mögen insbesondere zeitsynchron gekoppelt sein, Zeitsynchronität mag somit jederzeit zwischen Realität und Virtualität vorhanden sein. D.h. eine Messung im realen Modell mag im Wesentlichen zeitgleich im Virtuellen verfügbar sein, somit einerseits durchgeführt werden andererseits der Messwert der realen Messung ins virtuelle Modell übermittelt worden sein. Insofern eine im Wesentlichen zeitgleiche Verfügbarkeit nicht gewährleistet ist, mag eine Kompensation einer Latenz notwendig sein. Wenn beispielsweise ein Messpunkt im realen gesetzt wird und eine zugehörige Funktion, z.B. die Positionsbestimmung ausgelöst wird, mag es notwendig sein, sicherzustellen, dass im virtuellen Modell die Position des Messfühlers zu dem Zeitpunkt des Auslösens verwendet wird..

Ein Aspekt der vorliegenden Erfindung mag somit als eine Integration von Werkzeugen im realen als auch im virtuellen Raum sein. Eine gezielte Kombination von realen Werkzeugen und virtuellen Werkzeugen stellt einen entscheidenden Fortschritt dar. Besonders bevorzugt sind in Kombination mit den Werkzeugen auch die aufgezeigten Einsatzmöglichkeiten.

Eine Werkzeugelement mag einerseits ein zweites Positionsbestimmungselement sein oder aber das zweite Positionsbestimmungselement mag an einem Werkzeugelement anbringbar, insbesondere definiert anbringbar sein.

Ein weiterer Aspekt der vorliegenden Erfindung mag eine Anordnung zur kombinierten Darstellung eines realen und eines virtuellen Modells sein, aufweisend ein reales Modell, welches ein reales Koordinatensystem aufweist, ein virtuelles Modell, eine Visualisierungsvorrichtung, ein erstes Positionsbestimmungselement und eine Positionsbestimmungsvorrichtung. Das erste Positionsbestimmungselement mag an der Visualisierungsvorrichtung anbringbar sein, wobei unter Verwendung der Positionsbestimmungsvorrichtung eine Position und/oder Orientierung des ersten Positionsbestimmungselementes bestimmbar sein mag. Die Visualisierungsvorrichtung mag derart eingerichtet sein, zumindest einen Teil des virtuellen Modells darzustellen, wobei der dargestellte Teil des virtuellen Modells von Position und/oder Orientierung des ersten Positionsbestimmungselementes abhängig sein mag. Auch mag ein Positionsbestimmungselement im Kontext der realen Umgebung angebracht sein, über welches die Bestimmung der Position/Orientierung der Positionsbestimmungsvorrichtung und der daran angeschlossenen Werkzeuge im realen und virtuellen Modell ermöglicht wird. Dies mag durch gleiche Koordinatensysteme und/oder eine bekannte Umrechnungsvorschrift realisierbar sein, um Raum "real" in Raum "virtuell" bzw. umgekehrt abzubilden.

Ein weiterer Aspekt der vorliegenden Erfindung mag ein Verfahren zur Simulation eines virtuellen Modells im Kontext eines realen Modells sein, aufweisend die Schritte Bereitstellen eines referenzierten realen Modells, Bereitstellen eines referenzierten virtuellen Modells und Darstellen des virtuellen Modells unter Verwendung der Referenz des realen Modells.

Eine logisch-funktionale Zuordnung eines realen Werkzeugelementes und eines virtuellen Werkzeugelementes mag insbesondere als Verknüpfung des realen Werkzeugelementes und des virtuellen Werkzeugelementes derart verstanden werden, dass Messwerte oder Parameter eines Werkzeugelementes eines Modells mit denen des anderen Werkzeugelementes der anderen Modells verknüpft bzw. einander zugeordnet sind. Werkzeugelement wirken hierbei im Wesentlichen identisch, soweit ein reales Werkzeugelement und ein virtuelles Werkzeugelement identisch wirken können. Auch eine Steuerung eines virtuellen Werkzeugelementes durch ein reales Werkzeugelement mag denkbar sein. Ein Messwert eines Werkzeugelementes mag sich somit automatisch in den Kontext des jeweils anderen Werkzeugelementes einbinden bzw. übertragen lassen.

Die Funktion eines real/virtuellen Werkzeugelementes auf die Funktion eines virtuell/realen Werkzeugelementes abzubilden mag insbesondere derart verstanden werden, dass eine geforderte oder gewünschte Funktion in identischer Weise, soweit ein reales Werkzeugelement und ein virtuelles Werkzeugelement identische Funktionen haben können, implementiert sind. So mag z.B. ein reales Werkzeugelement, welches eine Position ermitteln oder anzeigen mag, dieselbe Funktion in einem logisch-funktional zugeordneten virtuellen Werkzeugelement umsetzen. In anderen Worten mag das virtuelle Werkzeugelement ebenfalls eingerichtet sein, eine Position anzuzeigen bzw. zu ermitteln, jedoch im jeweiligen anderen Modell, hier somit im virtuellen Modell. Auch mag ein virtuelles Farbmessgerät einen Farbwert eines Elementes des virtuellen Modells ermitteln, welcher Farbwert mit dem ermittelten Farbwert eines realen Farbmessgerätes verglichen werden mag.

Eine Funktion mag im virtuellen Modell und im realen Modell im Wesentlichen identisch sein oder mag sich zumindest logisch entsprechen. Zum Beispiel bohrt eine reale Bohrmaschine auch im virtuellen Modell Löcher. Hierzu mag die reale Bohrmaschine im virtuellen Modell Bohrpunkt, -vektor und Durchmesser annotieren. Andererseits mag eine virtuelle Bohrmaschine eine 8m Bohrung im virtuellen Modell definieren. Beim Verwenden des realen Werkzeuges mag daraufhin der Bohrertyp sowie Position & Vektor der Bohrung verifiziert und/oder unterstützend angezeigt werden.

Somit mögen sich Parameter, also Freiheitsgrade des Werkzeuges, entsprechend realvirtuell oder virtuell-real abbilden lassen. Eine genaue Funktion bzw. Implementierung mag jedoch insbesondere vom aktuell geforderten Einsatzzweck abhängig sein.

Weiter bevorzugte Ausgestaltungen ergeben sich aus den abhängigen Ansprüchen.

Die nachfolgenden Ausführungen beziehen sich auf eine Anordnung zur kombinierten Darstellung eines realen und eines virtuellen Modells sowie auf das Verfahren zur Simulation eines virtuellen Modells im Kontext eines realen Modells. Derartige Ausführungen sind jedoch nicht als einschränkend aufzufassen, vielmehr gelten die nachfolgenden Ausführungen sowohl für die Anordnung, das Verfahren als auch die Verwendung der Anordnung.

Gemäß einer weiteren exemplarischen Ausgestaltung der vorliegenden Erfindung mag zumindest eine Funktion des realen Werkzeugelementes auf zumindest eine Funktion des virtuellen Werkzeugelementes abbildbar und/oder zumindest eine Funktion des virtuellen Werkzeugelementes auf zumindest eine Funktion des realen Werkzeugelementes abbildbar sein.

Somit mag eine im Wesentlichen identische Funktion im virtuellen und/oder im realen Modell durchgeführt werden, wobei das Ergebnis der Funktion, z.B. das Ermitteln eines Messwertes oder Parameters, in einem Modell das jeweils andere Modell zu beeinflussen vermag.

Gemäß einer weiteren exemplarischen Ausgestaltung der vorliegenden Erfindung mag die zumindest eine Funktion eine Funktion sein aus der Gruppe bestehend aus Bestimmung von Position, Orientierung, Fertigungsgenauigkeit, Farbwert, Helligkeitswert, Motion-Tracking, Überwachung eines Arbeitsablaufes und Auslösen einer Aktion.

Die Funktion mag über verschiedene Sensoren, z.B. bezüglich Position, Orientierung, drücken eines Knopfes für Messtaster, Bohrmaschine erfasst und mit der virtuellen Instanz abgeglichen werden. Die Funktion mag sich hierbei über das Werkzeug, z.B. Farbmessgerät, Positionsmessgerät, Bohrmaschine bestimmen, somit eine werkzeugspezifische Funktion aufweisen. z.B. mag sich ein Metallteil, welches im realen Modell mit einem Hammer bearbeitet wird im virtuellen Modell verformen. Wenn ein, reales, Auto mit entsprechenden Sensorik, z.B. Beschleunigung und/oder Verformung, gegen ein Hindernis fährt, mag ein CAD-Modell verformt werden bzw. das virtuelle Modell entsprechende Schäden aufzeigen. Beide Beispiele stellen somit vereinheitlichte Werkzeuge und somit eine echte integriert real/virtuelle Produktentwicklung dar.
Die Simulation im virtuellen Modell mag sich somit direkt an das reale Verhalten koppeln und entsprechend verifizieren, z.B. Werkzeug zum Zählen der Personen pro Notausgang oder Peopletracking.

Allgemein werden somit Parametern, z.B. Input und Output, von Werkzeugen zwischen real und virtuell abgebildet, z.B. ein Messtaster mit Knopf, wessen Knopf eine Messung auslöst, welche Messung bzw. Information zur Messung im Weiteren an ein virtuelles/reales Gegensystem übertragen werden mag. Ein Benutzer mag somit mit einem Werkzeug eine oder mehrere Aktionen auslösen, die dann zu einer entsprechende Reaktion führen, welche beide in identischer oder vergleichbarer Form im realen und virtuellen Raum zur Verfügung stehen.

Gemäß einer weiteren exemplarischen Ausgestaltung der vorliegenden Erfindung mag die Positionsbestimmungsvorrichtung derart eingerichtet sein, die Position und/oder Orientierung des ersten Positionsbestimmungselementes zu bestimmen.

Hierdurch mag sich eine definierte Position und/oder Orientierung des ersten Positionsbestimmungselementes und somit der Visualisierungsvorrichtung in einem Raumabschnitt beispielsweise eines realen Modells angeben lassen.

Gemäß einer weiteren exemplarischen Ausgestaltung der vorliegenden Erfindung mag die Position und/oder Orientierung des ersten Positionsbestimmungselementes in Relation zum realen Koordinatensystem bestimmbar sein.

Hierdurch mag sich insbesondere eine Bewegung der Visualisierungsvorrichtung im Raum des realen Modells angeben lassen.

Gemäß einer weiteren exemplarischen Ausgestaltung der vorliegenden Erfindung mag der dargestellte Teil des virtuellen Modells von Position und/oder Orientierung des ersten Positionsbestimmungselementes in Relation zum realen Koordinatensystem abhängig sein.

Somit mag es ermöglicht werden, dynamisch eine Darstellung eines Teils des virtuellen Modells bei einer Bewegung der Visualisierungsvorrichtung durch den Raum des realen Modells anzupassen.

Gemäß einer weiteren exemplarischen Ausgestaltung der vorliegenden Erfindung mag die Anordnung ein zweites Positionsbestimmungselement aufweisen, wobei das zweite Positionsbestimmungselement derart eingerichtet sein mag, eine Relation des realen Koordinatensystems mit dem ersten Positionsbestimmungselement und/oder der Positionsbestimmungsvorrichtung festzulegen.

Unter Verwendung des zweiten Positionsbestimmungselementes mag sich somit das reale Modell bzw. der Raum des realen Modells mit der Positionsbestimmungsvorrichtung referenzieren lassen und somit eine bekannte Relation zu realem Modell und zumindest der Visualisierungsvorrichtung bereitstellen.

Gemäß einer weiteren exemplarischen Ausgestaltung der vorliegenden Erfindung mag die Visualisierungsvorrichtung zumindest ein Element aufweisen aus der Gruppe, bestehend aus Speicherelement und Prozessorelement, wobei das zumindest eine Element derart eingerichtet sein mag, zumindest einen Teil des virtuellen Modells zur Darstellung bereitzustellen.

Somit mag das virtuelle Modell auf der Visualisierungsvorrichtung vorgehalten werden, um im Bedarfsfall unter Verwendung einer Position bzw. Relation zum realen Modell dargestellt zu werden. Ein Prozessorelement mag hierbei nötige Berechnungen bzw. Umformatierungen von darzustellendem Modell bereitstellen oder aber mag beispielsweise Konfigurationsfunktionen implementieren.

Gemäß einer weiteren exemplarischen Ausgestaltung der vorliegenden Erfindung mag die Visualisierungsvorrichtung ein Kommunikationselement aufweisen, wobei unter Verwendung des Kommunikationselementes Daten zu Position, Orientierung und/oder darzustellendem Teil des virtuellen Modells empfangbar sind.
Unter Verwendung eines, möglicherweise bidirektionalen,

Kommunikationselementes mag es somit nicht notwendig sein, Informationen zum virtuellen Modell selbst auf der Visualisierungsvorrichtung vorzuhalten. Somit mag eine Detektion von Position und Orientierung unabhängig von der Visualisierungsvorrichtung erfolgen, welche letztendlich nur Informationen bzw. Daten empfängt, welche auf der Visualisierungsvorrichtung angezeigt werden. Somit mögen Informationen nicht auf einem mobilen Endgerät visualisiert sondern z.B. auf einem zentralen Server, beispielsweise in Echtzeit aufbereitet werden. Dies mag es ermöglichen internen Datenprozesse zu verwenden und zudem die Anforderungen an das Mobilgerät gering zu halten. Des weiteren mögen so nur verschlüsselte abstrakte Informationen z.B. als Videostream übertragen werden und es mag nicht nötig sein, die 3D Produktdaten auf eine Visualisierungsvorrichtung zu übertragen. Des weiteren mag dies die Sicherheit der Anwendung erhöhen und z.B. das Nutzen von WLAN ermöglichen.

Gemäß einer weiteren exemplarischen Ausgestaltung der vorliegenden Erfindung mag die Visualisierungsvorrichtung eine Informationsaufnahmevorrichtung aufweisen, wobei die Informationsaufnahmevorrichtung eingerichtet ist, zumindest eine Teilinformation des realen Modells aufzunehmen.

Beispielsweise mag die Informationsaufnahmevorrichtung eine Foto- bzw. Videokamera sein, um ein Videobild oder Foto des realen Modells aufzunehmen und abzubilden. Diese Aufnahme mag nachfolgend zumindest teilweise vom virtuellen Modell überlagerbar sein, um somit einen gesamten, einheitlichen optischen Eindruck zu vermitteln, welcher aus realem und virtuellem Modell besteht.

Gemäß einer weiteren bevorzugten Ausgestaltung der vorliegenden Erfindung mag die Visualisierungsvorrichtung eingerichtet sein, zumindest einen Teil des virtuellen Modells derart darzustellen, so dass es zumindest mit einem Teil des aufgenommenen realen Modells überlagerbar ist.

Somit lässt sich ein kombiniertes, real-virtuelles Modell bereitstellen, welches einerseits den Eindruck eines realen Modells vermitteln, andererseits jedoch die Konfigurationsmöglichkeiten eines flexiblen virtuellen Modells aufweisen mag.

Gemäß einer weiteren exemplarischen Ausgestaltung der vorliegenden Erfindung mag die Visualisierungsvorrichtung portabel eingerichtet sein.

Auf diese Weise mag ein einfaches Versetzen bzw. ein Gang durch das reale Modell durch einen Benutzer möglich sein, um ein kombiniertes real-virtuelles Modell aus verschiedenen Perspektiven zu betrachten.

Gemäß einer weiteren exemplarischen Ausgestaltung der vorliegenden Erfindung mag ein Parameter des realen Modells ermittelbar sein, wobei unter Verwendung des Parameters das virtuelle Modell veränderbar ist.

Gleichfalls mag ein Parameter des virtuellen Modells unabhängig vom realen Modell veränderbar sein. Ein derartiger Parameter mag beispielsweise eine Position, eine Orientierung, eine Farbe, ein Helligkeitswert oder auch Metadaten sein.

Ein spezieller Anwendungsbereich einer Mixed Reality-Applikation mag beispielsweise im Gebiet des Flugzeugbaus gesehen werden. Im Flugzeugbau bzw. generell in Großprojekten, die einen vergleichbaren Planungsaufwand erfordern, wie beispielsweise der Fahrzeugbau allgemein oder aber auch der Konstruktionsbau, mag im Rahmen der Planung ein vollständiges dreidimensionales Referenzmodell, ein sogenanntes digitales Mockup (DMU), mithin ein virtuelles Modell, Verwendung finden, welches teilweise oder vollständig unter Verwendung von 3D CAD-Entwicklungsmethoden bzw. Software erstellt wurde.

Eine erfindungsgemäße Mixed Reality-Applikation mag insbesondere in Flugzeugproduktionsstätten eingesetzt werden. Dort sind zu den zu bauenden Flugzeugen meist dreidimensionale Masterreferenzdaten (DMU) verfügbar. Dadurch ist es möglich, im Rahmen des Flugzeugbaus einen Vergleich zwischen der geplanten Version gemäß virtuellem Modell mit der realen Umsetzung, somit dem realen Aufbau des Flugzeugs gemäß den vorgegebenen Planungsdaten zu ziehen. In anderen Worten mag eine entsprechende Applikation einen einfachen Vergleich der Planungsversion (as planned) mit der umgesetzten, aufgebauten Version (as built) eines Flugzeuges ermöglichen.

Herkömmliche Messsysteme mögen hierbei beispielsweise spezielle Referenzpunkte verwenden, die in einem Planungsstadium im virtuellen Modell festgelegt wurden, um die Produktionsqualität, insbesondere bezüglich Fertigungstoleranzen, des realen Modells zu überprüfen. Entsprechende Referenzpunkte sind zumeist fest in einem Flugzeug eingebaut. Ein entsprechendes Messsystem mag insbesondere als ein Offline-Verfahren betrieben werden, in welchem einzelne Messwerte im realen erstellt und nachfolgend mit geforderten Vorgaben, beispielsweise aus dem Planungsmodell oder der Planungsvorlage, verglichen werden. Ein entsprechender Vergleich mit dem virtuellen 3D-Referenzmodell mag beispielsweise vor Ort im Flugzeug unter Verwendung von leistungsfähigen Workstation-PCs erfolgen, welche zur Darstellung des (vollständigen) Referenzmodells eingerichtet sind. Andererseits mögen Installationsdokumente, beispielsweise in gedruckter Form oder in digitaler Form, auf einem entsprechenden Anzeigeinstrument, zum Beispiel einem PDA, vorliegen.

Insbesondere ist es für alle Flugzeughersteller gefordert, die eine 3D CAD-Software im Flugzeugdesign einsetzen, dass das letztendlich hergestellte Produkt, somit das aufgebaute Flugzeug (as-built), im Rahmen erlaubter Toleranzen, vollständig dem geplanten Modell (as-planned) entspricht. Hieraus ergibt sich, dass das real produzierte Flugzeug letztendlich ein Abbild des digitalen Mockups sein soll.

Die Flugzeugproduktion unterscheidet zwei Hauptphasen, die Pre-FAL-Phase und die FAL-Phase (Final Assembly Line). Die Pre-FAL-Phase wird auch als MCA-Phase (Major Component Assembly) bezeichnet, die wiederum aufgeteilt ist in den (Auf-)Bau der Flugzeugstruktur und die Installation der Flugzeugsysteme, wie beispielsweise Leitungen, Be- und Entlüftungsrohre sowie weitere Ausrüstungskomponenten.

Insbesondere im Rahmen der Systeminstallationsphase erhält ein Arbeiter eine Zeichnung oder allgemein eine Vorlage, welche die zu installierenden Komponenten darstellt. Diese Zeichnung mag beispielsweise aus dem digitalen Mockup bzw. aufgrund des virtuellen Modells erstellt worden sein. Dies kann mittels einer Ableitung aus unterschiedlichen Perspektiven als 2D Zeichnung oder auch als annotiertes 3D Modell in einer digitalen Bauunterlage vorliegen. Aus der Zeichnung/dem Modell entnehmbar sind die genauen zu verwendenden Bauteile, zum Beispiel Klammern, Schellen, Abzüge, Rohre oder ganz allgemein Ausrüstungskomponenten sowie deren exakte Position im Flugzeug, wie im Referenzmodell geplant.

Hierbei werden beispielsweise Koordinaten eines Installationsortes in Bezug auf vorgegebene Referenzpunkte bereitgestellt. Eine Orientierung in einem Flugzeug oder einer Hauptkomponente, welche sich im Aufbau befindet, beispielsweise eine Rumpfsektion, eine Flügelsektion oder dergleichen mag nicht immer einfach und/oder präzise durchführbar sein. Hieraus mag sich ergeben, dass einzelne Elemente an einem falschen Ort und/oder mit einer falschen Orientierung installiert werden. Ein weiterer typischer Fehler mag das verwenden eines falschen Standardbauteiles (zBsp eines Halters) oder das anbringen an der falschen Seite eines Bauteiles sein, also entweder von oben oder von unten aufliegend befestigt. Das Bohrloch mag an der richtigen Position, der Halter jedoch von der falschen Seite festgeschraubt sein.

Ein entsprechender fehlerhafter Aufbau muss jedoch vor Fertigstellung korrigiert werden, so dass verschiedene weitere Kontrollphasen, zur Qualitätssicherung, vorgesehen werden müssen, welche Ortsposition und Einbaurichtung von installierten Elementen überprüfen. Eine entsprechende Überprüfung wird meist manuell, wiederum unter Verwendung von 2D-Zeichnungen oder des 3D-DMU, des virtuellen Modells, durchgeführt. Eine entsprechende Qualitätssicherung mag somit als ein beträchtlicher Arbeitsaufwand gesehen werden.

Die vorliegende Mixed Reality-Applikation mag nun insbesondere eine vereinfachte Hilfestellung beim initialen Anbringen, bei der Installation eines Bauteils in einem Flugzeug bereitstellen oder aber mag gleichfalls nachfolgende Qualitätssicherungsschritte vereinfachen.

Das erfindungsgemäße System mag somit sowohl qualitativ (Visualisierung des DMU) als auch quantitativ (Messpitze/Taster um die Bauteilpositionierung im realen sowie im digitalen Modell (DMU) zu überprüfen) verwendet werden.

Eine Vereinfachung mag insbesondere dadurch erzielt werden, dass eine Visualisierungsvorrichtung verwendet wird, die einerseits ihre Position im Flugzeug "kennt", sich somit selbst zu lokalisieren vermag, und gleichzeitig, insbesondere positions- und/oder orientierungsabhängig 2D oder 3D-Informationen des virtuellen Modells bereitstellt, zum Beispiel einem Benutzer anzeigt, welcher hierdurch positions- und/oder orientierungsabhängig aktuelle Informationen zu den im Flugzeug zu verbauende Komponenten erhält. Weiterhin denkbar sind die Anzeige zusätzlicher Informationen, z.B. mag auch angezeigt werden, mit welchem Drehmoment eine bestimmte Schraubverbindung angezogen werden muss um geforderten Vorgaben zu entsprechen. Letztendlich lässt sich so eine virtuelle und interaktive Installationsanleitung realisieren.

Über eine entsprechende Bereitstellung von visualisierten virtuellen Modellinformationen mag auch eine nachfolgende Qualitätskontrolle vereinfacht möglich sein. Mittels der Visualisierungsvorrichtung wird ein vereinfachter Zugriff auf das virtuelle Modell bzw. das digitale Mockup ermöglicht, indem unter Berücksichtigung einer Position und/oder Orientierung (Pose) im Flugzeug ein adäquater Ausschnitt aus dem virtuellen Modell einem Benutzer angezeigt wird. Einzelne durchzuführende Arbeitsschritte können nun gleichfalls angezeigt werden, zusammen mit zum Beispiel einer Auflistung zu verbauender Komponenten, die hierzu zur Verfügung stehenden bzw. benötigten Werkzeuge sowie durchzuführende Arbeitsschritte.

Nach erfolgtem Einbau einer Komponente mag mittels der Visualisierungsvorrichtung eine manuelle oder automatisierte Qualitätskontrolle erfolgen. In einem an die Anordnung angegliederten globalen Bauplansystem oder auch beispielsweise einer einfachen Checkliste mag der ordnungsgemäße Einbau der Komponente registriert, beispielsweise als vorgenommen markiert werden. Unter Verwendung einer entsprechenden Visualisierungsvorrichtung mag sich somit ein Innenaufbau schrittweise einem Benutzer darstellen, welcher gleichzeitig detaillierte Anweisungen zur Durchführung erhält und nachfolgend auch eine direkte Überprüfung der vorgenommenen Aktion ermöglicht. Weitergehende Möglichkeiten wurden bereits vorangehend beschrieben.

Ein mögliches Anwendungsszenario mag somit wie folgt dargestellt erfolgen.

Zu einem bestimmten Zeitpunkt im Produktionsprozess eines Flugzeugs mag die Visualisierungsvorrichtung einem Benutzer als nächsten durchzuführenden Arbeitsschritt die Installation eines Elementes, beispielsweise eines Kabelkanals, vorgeben. Das System mag hierbei dem Benutzer einerseits die benötigten Komponenten, z.B. Kabelkanal und Befestigungsmaterial anzeigen, beispielsweise inklusiv Bauteilreferenznummer sowie Lagerort. Weiterhin mag der Benutzer Informationen über die benötigten Werkzeuge zur Installation erhalten, möglicherweise gleichfalls wieder mit eindeutiger Referenznummer sowie derzeitigem Lagerort. Der Benutzer mag für die Installation somit die benötigten Komponenten zusammenstellen und zur Installation im Flugzeug bereitlegen können.

Die Visualisierungsvorrichtung mag nachfolgend, manuell oder automatisch, feststellen, dass die entsprechende Installation im Begriff ist zu beginnen. Arbeitsanweisungen für die Installation mögen auf der Visualisierungsvorrichtung angezeigt werden. Einzelne Arbeitsschritte mögen hierbei detaillierter als andere dargestellt sein.

Ein Benutzer erhält somit für einen bestimmten Arbeitsablauf explizite Anweisungen, was, wie, wo, wann zu installieren ist. Nach erfolgter Installation mag über die Visualisierungsvorrichtung unmittelbar eine Qualitätskontrolle erfolgen.

Eine Qualitätskontrolle mag erfolgen, indem ein Benutzer ein reales Werkzeugelement oder eine Anzeigevorrichtung, verwendet, welche gleichfalls im Raum in Relation zu Flugzeugstruktur und Visualisierungsvorrichtung lokalisiert werden mag, um einzelne Referenzpunkte bzw. Messpunkte anzufahren und auf diese Weise überprüfen zu können, ob geforderte Toleranzen eingehalten werden.

Auch denkbar ist, dass die Visualisierungsvorrichtung das installierte Element selbst, beispielsweise durch die Erkennung der Form des Elementes, z.B. über Kantendetektion, zum Beispiel mittels einer Informationsaufnahmevorrichtung, z.B. einer Kamera, erkennt, eine entsprechende Position und/oder Orientierung zu bestimmen vermag und, aufgrund einer detektierten Position und/oder Orientierung das Einhalten geforderter Toleranzvorgaben feststellen mag. Im Falle, dass eine korrekte Installation erfolgt ist, mag in einem Installationsprotokoll, manuell oder automatisch, ein entsprechender Vermerk gesetzt werden. Denkbar sind auch Verfahren die auf eine 3D Kamera, z.B. eine Time-of-Flight-Kamera) oder Laserscanner zurückgreifen.

Bei Verwendung einer erfindungsgemäßen Anordnung mag somit der Installationsaufwand reduziert und gleichzeitig die Herstellungsqualität gesteigert werden. Langwierige, möglicherweise mehrfache Qualitätskontrollschritte, mögen gleichfalls zeitoptimiert durchgeführt werden. Der Zeitaufwand zum beheben eines Fehlers übersteigt meist das simple Entfernen und Neupositionieren da ggf. Bohrlöcher entweder verklebt, z.B. bei Kohlefaser, oder mit Blindnieten versehen werden müssen um die Kräfte entsprechend abzuleiten.

Um die präzise Lokalisierung einer Visualisierungsvorrichtung bzw. deren Selbstlokalisierung in einer Struktur, beispielsweise im Flugzeugrumpf, welcher sich derzeit im Aufbau befindet, zu ermöglichen, mag insbesondere ein Positionsbestimmungselement verwendet werden, welches definiert im bzw. am Flugzeug, somit im/am realen Modell angebracht ist.

Das Positionsbestimmungselement mag entweder an definierten Positionen, welche beispielsweise bereits im virtuellen Modell referenziert sind, angebracht werden und somit einen Bezug eines virtuellen Koordinatensystems eines virtuellen Modells mit einem realen Koordinatensystem eines realen Modells herstellen.

Oder aber ein Positionsbestimmungselement mag im Wesentlichen frei bzw. beliebig im realen Modell, jedoch fest in Relation zum realen Modell angebracht werden und nachfolgend bezüglich seiner Position im realen Modell basierend auf dem virtuellen Modell referenziert werden.

Beispielsweise mag das Positionsbestimmungselement oder Referenzmarker an einem Teil der Flugzeugstruktur angebracht werden. Das Positionsbestimmungselement hat einerseits Komponenten, die beispielsweise über eine Visualisierungsvorrichtung oder aber über eine Positionsbestimmungsvorrichtung identifiziert werden mögen. Gleichzeitig mag das Positionsbestimmungselement, insbesondere im zweiten Fall, Referenzpunkte aufweisen, die eine Lokalisierung im realen Modell sowie gleichzeitig im virtuellen Modell ermöglichen. Somit mag beispielsweise das virtuelle Modell, insbesondere temporär, um die exakte Position des Positionsbestimmungselementes im realen Modell ergänzt werden kann. Ist eine definierte Position und/oder Orientierung des ersten Positionsbestimmungselementes sowohl im realen Modell als auch im virtuellen Modell bekannt, kann beispielsweise über eine Visualisierungsvorrichtung, welche die eigene Position und/oder Orientierung in Relation zum ersten Positionsbestimmungselement zu detektieren vermag, gleichzeitig die Position und/oder Orientierung der Visualisierungsvorrichtung im realen Modell erkannt und gleichzeitig im virtuellen Modell bereitgestellt werden.

Eine entsprechende feste Anbringung eines ersten Positionsbestimmungselementes am/im realen Modell mag nachfolgend einen festen Bezugspunkt für eine Visualisierungsvorrichtung darstellen, um eine (Selbst-) Lokalisation im realen Modell sowie im virtuellen Modell vorzunehmen.

Sowohl das reale Modell als auch das virtuelle Modell mögen in unterschiedliche Bau- bzw. Aufbauphasen gegliedert sein. So mag beispielsweise im realen Modell zunächst die Rumpfstruktur aus Einzelelementen aufgebaut werden, nachfolgend mag beispielsweise innenliegend eine Isolierung aufgebracht werden, auf welche im Weiteren Kabelleitungen, Lüftungsschächte, etc. installiert werden. Im Anschluss mag beispielsweise der Einbau einer Verkleidung erfolgen. Die einzelnen dargestellten Schritte sind hierbei vereinfacht dargestellt. Zu den einzelnen Bauabschnitten des realen Modells mögen verschiedene Planungsstadien bzw. virtuelle Produktionsstadien im virtuellen Modell verfügbar sein. Beispielsweise mag das virtuelle Modell, nachdem sämtliche zwischen Isolierung und Verkleidung liegenden Elemente installiert sind, von einem derartigen Modellzustand, in welchem die zwischenliegenden Elemente sichtbar sind, auf einen weiteren Zustand umgeschaltet werden, welcher für die Installation der Verkleidungselemente verwendet werden mag.

Auch mag es vorkommen, dass bei einem realen Aufbau des virtuellen Modells Schwierigkeiten auftreten, welche in der Planungsphase, somit im virtuellen Modell, nicht berücksichtigt wurden. Hierbei mag nun eine Anpassung des realen Modells, insbesondere in Abweichung zum virtuellen Modell, erfolgen. Diese Abweichungen mögen, beispielsweise über die Visualisierungsvorrichtung oder ein reales Werkzeugelement, aufgenommen bzw. detektiert und in das virtuelle Modell zurückgespielt werden. Hierdurch mögen anhand des realen Modells Fehler im virtuellen Modell ausgeräumt und dieses weiter optimiert werden.

Reales Modell und virtuelles Modell müssen letztendlich im Rahmen gewisser vorgegebener Produktionstoleranzen übereinstimmen, was insbesondere Voraussetzung für eine nachfolgende Flugverkehrszulassung ist. Für die erfindungsgemäße Applikation mag ein Softwaresystem verwendet werden, welches eingerichtet ist, die Pose einer erfindungsgemäßen Visualisierungsvorrichtung in Echtzeit bereitzustellen. Dies mag beispielsweise eine vorregistrierte bzw. detektierte (Koordinaten-) Transformation zwischen dem realen Modell mit angeordnetem Positionsbestimmungselement und/oder eine Transformation zwischen Visualisierungsvorrichtung und Positionsbestimmungselement bereitstellen.

Als Referenzierung mag im Weiteren der Prozess verstanden werden, die Pose der Positionsbestimmungsvorrichtung im Flugzeug zu ermitteln, welches einmalig sein kann sofern sich diese nicht ändert. Als Online Registrierung mag im Weiteren verstanden werden, wenn die Registrierung selbstständig während des Einsatzes ermittelt und so die Positionsbestimmungsvorrichtung oder aber die Visualisierungsvorrichtung, sofern diese über entsprechende Elemente, z.B. eine Informationsaufnahmevorrichtung, aufweist, bewegt werden mag. Dies mag die Flexibilität des Systems Bzw. der Anordnung erhöhen, da diese hierdurch z.B. auf Stöße und Erschütterungen reagieren kann.

Als Lokalisierung der Visualisierungsvorrichtung mag im Weiteren der Gesamtablauf verstanden werden, um dieses im Koordinatensystem des realen Modell zu kennen, somit eine Abfolge Flugzeug->Referenzmarke->Registeriung->Positionserfassungssystem->Visualisierungsvorrichtung.

Für eine entsprechende. Lokalisierung der Visualisierungsvorrichtung ist auch eine Registrierung notwendig. Eine Online-Registrierung mag darunter verstanden werden, insbesondere dadurch, dass die Positionsbestimmungsvorrichtung letztendlich als eine mobile Positionsbestimmungsvorrichtung ausgelegt sein mag, welche nicht statisch montiert, insbesondere nicht statisch in Bezug auf das erste Positionsbestimmungselement bzw. das reale Modell festgelegt ist, sondern vielmehr die eigene Position im Flugzeug variieren und zu jeder Zeit detektieren bzw. berechnen mag. Hierzu mag ein Referenzmarker, zum Beispiel das erste Positionsbestimmungselement, derart angeordnet sein, um durch die Informationsaufnahmevorrichtung der Visualisierungsvorrichtung detektiert werden zu können. Auch mag eine Positionsbestimmungsvorrichtung sowohl die Visualisierungsvorrichtung als auch das erste Positionsbestimmungselement bzw. Referenzmarker detektieren und über eine Detektion der Relation zwischen Visualisierungsvorrichtung und Positionsbestimmungselement eine Pose im realen Modell bestimmen und mit dem virtuellen Modell abgleichen.

Die Positionsbestimmungsvorrichtung und/oder Visualisierungsvorrichtung, im Falle dass letztere eine Informationsaufnahmevorrichtung umfasst, weist ein sogenanntes operatives Volumen auf, welches ein Raumvolumen darstellt, in dem ein Positionsbestimmungselement bzw. eine Visualisierungsvorrichtung angeordnet sein mag und von der Positionsbestimmungsvorrichtung respektive der Visualisierungsvorrichtung, über die Informationsaufnahmevorrichtung, detektiert werden mag. Bei erfolgter Detektion, somit bei dem Vorhandensein des Positionsbestimmungselementes oder allgemein eines Markers oder Referenzmarkers im operativen Volumen, mag eine Position und/oder Orientierung in Relation zum Positionsbestimmungselement und somit über die bekannte Transformation zwischen Positionsbestimmungselement und Flugzeug eine Position feststellbar sein.

Unterschiedliche reale Werkzeugelemente mögen von der Visualisierungsvorrichtung detektiert und unterschieden werden können. Hierbei können visuelle oder elektronische Marker und/oder individuelle Positionsbestimmungselemente an einem Werkzeugelement angebracht sein, einerseits zur Detektierung der Art des Werkzeugelementes, andererseits zur Bestimmung seiner Position und/oder Orientierung. Durch individuelle Positionsbestimmungselemente an einem Werkzeugelement mag sich unter Verwendung der Visualisierungsvorrichtung auch eine definierte Position im realen Modell für das jeweilige Werkzeugelement ergeben.

Einzelne Werkzeugelemente mögen der Visualisierungsvorrichtung bekannt sein. Dies mag insbesondere eine Funktion, beispielsweise die Funktion einer Bohrmaschine, oder aber die Abmaße des Werkzeugelementes beinhalten, beispielsweise somit die Spitze eines Bohraufsatzes der Bohrmaschine sowie die Orientierung im Raum. Hierdurch mag sich beispielsweise eine unterstützte Bohrung durch die Visualisierungsvorrichtung vornehmen, somit durch diese anleiten, lassen. Die Visualisierungsvorrichtung besitzt z.B. Informationen, wie ein gewünschtes Bohrloch im realen Modell zu setzen ist. Die Visualisierungsvorrichtung mag somit den Punkt des Bohrloches anzeigen und gleichzeitig Instruktionen zum Halten und/oder Bedienen eines Bohrwerkzeuges angeben, so dass ein gefordertes Bohrloch im Wesentlichen ausschließlich durch Vorgabe durch die Visualisierungsvorrichtung erstellt und dessen Umsetzung gleichzeitig überprüft und ggf. korrigiert werden mag.

Andere Anwendungen bzw. Funktionen von Werkzeugelementen mögen beispielsweise die Überprüfung einer Position, beispielsweise zur Detektion einer Fertigungstoleranz, sein. Ein Werkzeugelement mag sich somit als eine Messsonde bzw. eine Prüfspitze darstellen, die aufgrund des Wissens um ihre Position und Orientierung im Raum verwendet werden mag, um Positionen beliebiger Objekte bzw. spezieller Messpunkte im Raum anzuzeigen oder auch Abstände zwischen Objekten zu vermessen um somit zu überprüfen, inwieweit das virtuelle Modell und das reale Modell übereinstimmen.

Auch sind auch weitere Werkzeug-Bauteil Kombinationen denkbar, z.B. eine Schraubvorrichtung, die eine Schraube entsprechend eines vorgegebenen Drehmoments anzieht. Diese Information mag im virtuellen Modell vorliegen bzw. abgelegt sein. Hierdurch könne eine an die Anordnung logisch angebundene Schraubvorrichtung entsprechend des gerade gewünschten Arbeitsschritts mit dem passenden Drehmoment programmieren werden, so dass bei erfolgter Betätigung der Schraubvorrichtung durch den Benutzer im Wesentlichen automatisch die Auswahl des gewünschten Drehmoments erfolgt. Der Benutzer selbst muss hierbei nicht einmal zwingend über eine Drehmoment-Vorgabe informiert sein bzw. werden.

Die Visualisierungsvorrichtung mag, beispielsweise auf einem Display, eine Überlagerung von realem und virtuellem Modell vornehmen. Das reale Modell mag z.B. über die Informationsaufnahmevorrichtung der Visualisierungsvorrichtung aufgenommen und auf dem Display mit dem virtuellen Modell überlagert werden. Das virtuelle Modell mag hierbei nicht vollumfänglich dargestellt werden, es können beispielsweise gewisse Filterprozeduren verwendet werden, um zum Beispiel ausschließlich gewünschte Teile des virtuellen Modells auf das reale Modellabbild abzubilden. Beispielsweise ist es hierdurch möglich, ausschließlich Kabelkanäle aus dem virtuellen Modell in das reale Modell einzublenden und somit visuell, über die Visualisierungsvorrichtung, eine korrekte Installation zu verifizieren. Eine Filtermöglichkeit mag insbesondere auch für kontextsensitive Informationen, z.B. die aktuelle Gültigkeiten eines Bauteils implementiert sein. Diese beschreibt z.B. einen Zeitpunkt, einen Fertigungsort, einen Werksplatz, eine verantwortliche Firmengruppe, etc. an/von dem ein Bauteil verbaut wird bzw. werden darf.

Im Vergleich zu klassischen Messsystemen oder Real Time Tracking-Systemen stellt die erfindungsgemäße Anordnung eine erhöhte Flexibilität bereit, einerseits aufgrund seine Portabilität, andererseits da es weniger anfällig, beispielsweise gegenüber Vibrationen ist, aufgrund der festen Relation des ersten Positionsbestimmungselementes zum realen Modell. Eine nahtlose Integration der erfindungsgemäßen Anordnung in den Produktionsprozess, beispielsweise eines Flugzeugs, ist somit möglich. Aufgrund der vorbekannten Position eines ersten Positionsbestimmungselementes mag eine zeitaufwendige Registrierung des realen Modells unnötig sein. Messwerte mögen somit ohne Verzögerung ermittelt und die Registrierung entsprechend in Echtzeit angepasst werden

Im Rahmen der Anwendung der erfindungsgemäßen Anordnung mag eine Setup-Phase und eine Betriebsphase unterschieden werden.

In der Setup-Phase mögen Adapter bzw. Referenzmarker, zum Beispiel ein erstes Positionsbestimmungselement, am realen Modell, somit am Flugzeug, angebracht werden. Das Positionsbestimmungselement bzw. die Referenzmarker sind entweder bereits im virtuellen Modell bzgl. ihrer Pose vorregistriert oder aber müssen nun mittels bekannter Registrationsverfahren in Bezug auf das reale Modell räumlich festgelegt werden, um somit einen Bezug zwischen realem Modell und virtuellem Modell herstellen zu können.

Ein Positionsbestimmungselement mag hierbei zumindest drei Punkte bzw. Markerelemente aufweisen, welche über die Informationsaufnahmevorrichtung einer Visualisierungsvorrichtung oder mittels einer Positionsbestimmungsvorrichtung detektiert werden mögen.

Dies mag typischerweise zu einem einzigen Zeitpunkt während der Produktionsphase des Flugzeugs stattfinden. Das oder die erste(n) Positionsbestimmungselement(e), im Falle, dass das Flugzeug eine Mehrzahl von derartigen Positionsbestimmungselementen aufweist, mögen bis zur letztendlichen Fertigstellung im Flugzeug verbleiben und somit keine neue Registrierung auslösen.

Nachfolgend ist die Visualisierungsvorrichtung derart im Flugzeug zu platzieren, dass Referenzmarker bzw. Positionsbestimmungselemente in seinem operativen Volumen angeordnet sind und insbesondere ein Bereich sichtbar ist, welcher dem Bereich entspricht, in welchem eine Arbeit aktuell vorgenommen werden soll. Dieser Bereich wird auch als "Area of Interest" bezeichnet. Hier mag nun der Produktionsprozess, computerunterstützt durch die erfindungsgemäße Anordnung, beginnen. Das oder die ersten Positionsbestimmungselemente, welche definiert im/am realen Modell angebracht sind, mögen insbesondere erst im finalisierten Flugzeugzustand entfernt werden. Die Positionsbestimmungselemente mögen im Anschluss nachfolgend für ein weiteres Flugzeug der Produktion verwendet werden.

Die erfindungsgemäße Anordnung erlaubt im Betrieb die Messung von Koordinaten und Längen direkt im Herstellungsprozess. Die Registrierung ist nur einmal während des Setups erforderlich, zu welchem Zeitpunkt die ersten Positionsbestimmungselemente im Flugzeug somit im realen Modell installiert werden.

Insbesondere erfolgt ein Mal das Matching der Marker auf das reale Modell, z.B. ein Flugzeug in seiner im Wesentlichen Gesamtheit, beispielsweise durch Lasermessung, nachfolgend, während der Nutzung des Systems erfolgt die Registierung relativ zu diesen Markern, z.B. von der Visualisierungsvorrichtung und/oder realen Werkzeugelementen.

Die Visualisierungsvorrichtung stellt somit ein "Sichtfenster" in das virtuelle Modell dar und ermöglicht die Identifikation des Ortes und der Orientierung der Visualisierungsvorrichtung bei gleichzeitiger Abbildung eines Blicks auf das digitale Modell und z.B. Installationszeichnungen aus dem Blickwinkel der Pose der Visualisierungsvorrichtung. Dies mag sowohl für den Benutzer während des Installationsprozesses als auch für einen nachfolgenden Qualitätscheck hilfreich sein.

Hierdurch lässt sich nicht nur eine quantitative Abweichung beispielsweise eines Installationsortes feststellen, es ist vielmehr gleichzeitig möglich, die Abwesenheit eines vollständigen Elementes oder aber die falsche Installation eines Elementes, zum Beispiel aufgrund falscher Orientierung, durch eine visuelle Validierung zwischen realem und virtuellem Modell zu ermöglichen.

Die Visualisierungsvorrichtung mag es gleichfalls über Eingabeelemente verfügen, die eine integrierte Fehlerdokumentation ermöglichen, beispielsweise durch Informationseingabe oder auch über die Aufnahme von Bildern, zum Beispiel durch eine Kamera, welche gleichzeitig die Informationsaufnahmevorrichtung darstellen mag. Die Bilder mögen gleichfalls georeferenziert, bezogen auf das reale Koordinatensystem des realen Modells sein. Aufgrund des Wissens um eine exakte Position und Orientierung und beispielsweise auch der Brennweite einer Kamera mögen sich virtuelle Objekte in der gleichen Perspektive in die Abbildung des realen Modells der Visualisierungsvorrichtung einfügen lassen.

Mittels der erfindungsgemäßen Visualisierungsvorrichtung ist es auch möglich, Längen- und Positionsmessungen im virtuellen Modell vorzunehmen, ohne diese zwingend vorab vorzubereiten. Entsprechende Messungen können direkt am realen Modell reproduziert und überprüft werden, in Form einer quantitativen Überprüfung.

Weitere Ausführungsbeispiele und Vorteile der vorliegenden Erfindung ergeben sich aus der nachfolgenden Figurenbeschreibung. In verschiedenen Figuren werden gleiche oder ähnliche Elemente mit gleichen oder ähnlichen Bezugszeichen versehen.

Die Darstellung in den Figuren ist schematisch und nicht maßstäblich, mag jedoch qualitative Größenverhältnisse wiedergeben.
Figur 1a, b zeigen exemplarische Ausgestaltungen einer Positionsbestimmungsvorrichtung gemäß der vorliegenden Erfindung;
Figur 2 zeigt eine exemplarische Ausgestaltung eines zweiten Positionsbestimmungselementes gemäß der vorliegenden Erfindung;
Figur 3 zeigt eine exemplarische Kalibrierung einer Anordnung zur kombinierten Darstellung eines realen und eines virtuellen Modells gemäß der vorliegenden Erfindung;
Figur 4 a, b zeigen exemplarische Ausgestaltungen einer Visualisierungsvorrichtung gemäß der vorliegenden Erfindung;
Figur 5a,b zeigen eine exemplarische Ausgestaltung einer Anordnung zur kombinierten Darstellung eines realen und eines virtuellen Modells gemäß der vorliegenden Erfindung in 3D-Ansicht sowie Ansicht von oben;
Figur 6 zeigt eine exemplarische Ausgestaltung eines Verfahrens zur Simulation eines virtuellen Modells im Kontext eines realen Modells;
Fig. 7 zeigt eine exemplarische schematische Darstellung einer Anordnung zur Verifikation eines realen Modells und zur Verwendung eines virtuellen Modells gemäß der vorliegenden Erfindung;
Fig. 8 zeigt eine exemplarische Ausgestaltung eines Referenzmarkers gemäß der vorliegenden Erfindung;
Fig. 9a,b zeigen exemplarische Ausgestaltungen einer
Positionsbestimmungsvorrichtung mit zugehöriger Kalibrierungsvorrichtung gemäß der vorliegenden Erfindung;
Fig. 10,a,b zeigen eine exemplarische schematische Darstellung der Anordnung zur Verifikation eines realen Modells unter Verwendung eines virtuellen Modells gemäß der vorliegenden Erfindung;
Fig. 11a-c zeigen ein exemplarisches Anwendungsszenario der Anordnung gemäß der vorliegenden Erfindung; und
Fig. 12 zeigt eine exemplarische Ausgestaltung des Verfahrens zur Verifikation eines realen Modells unter Verwendung eines virtuellen Modells gemäß der vorliegenden Erfindung.

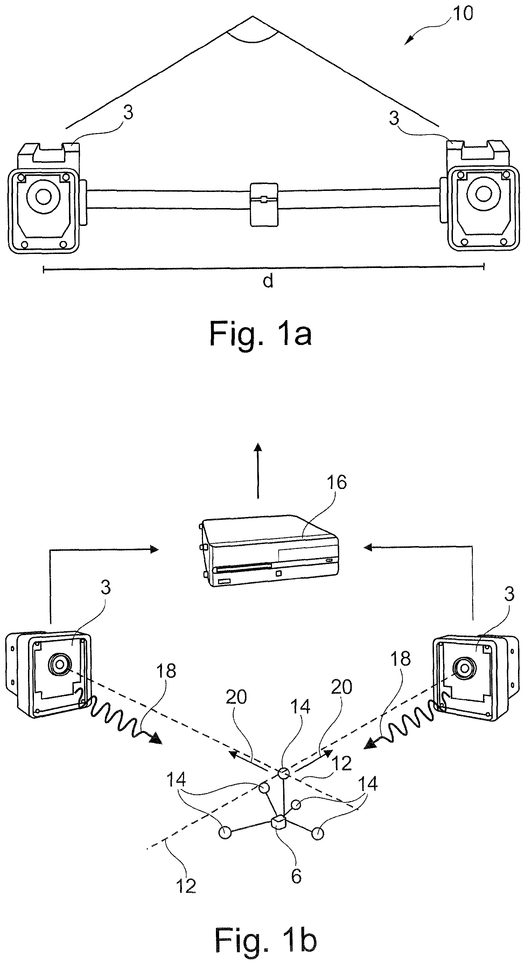

Bezug nehmend auf Figuren 1a,b ist eine exemplarische Ausgestaltung einer Positionsbestimmungsvorrichtung gemäß der vorliegenden Erfindung dargestellt.

Figur 1a zeigt eine Positionsbestimmungsvorrichtung 10, bestehend aus zwei Informationsaufnahmevorrichtungen, welche hier exemplarisch als Infrarotkameraelemente 3 dargestellt sind. Die beiden Infrarotkameraelemente 3 sind gemeinsam auf einem Träger zueinander in definiertem Abstand und definierter Orientierung montiert. Exemplarisch beträgt der Abstand d zwischen den beiden Infrarotkameraelementen 3. Die Infrarotkameraelemente 3 mögen zueinander angewinkelt sein unter dem Winkel α oder aber mögen auch parallel zueinander ausgerichtet sein, in diesem Fall ist α = 90°. Aufgrund eines gewissen Öffnungswinkels jedes der Infrarotkameraelemente 3 vermögen diese jeweils einen trichterförmigen Bereich zu erfassen, welche sich nach kurzer Entfernung von jedem Infrarotkameraelement 3 überlappen. Somit mag ein Element, welches sich im Überlappungsbereich des kegelförmigen Aufnahmebereichs jedes Infrarotkameraelements 3 befindet, von beiden Infrarotkameraelementen 3 detektiert werden.

Weiter Bezug nehmend auf Figur 1b wird eine schematische Darstellung der Detektion eines Markerelementes beschrieben.

In Figur 1b ist exemplarisch ein erstes Positionsbestimmungselement 6 dargestellt. Positionsbestimmungselement 6 besteht exemplarisch aus einer Anordnung von fünf infrarotaktiven bzw. Infrarotlicht reflektierenden Markern 14. Die Marker 14 sind derart am ersten Positionsbestimmungselement 6 angeordnet, um eine definierte Ausrichtung des Positionsbestimmungselementes 6 in einem beliebigen Raum zu bestimmen. Ein Infrarotmarker 14 ist exemplarisch dargestellt als von beiden Infrarotkameraelementen 3 erfasst werdend. Jedes Infrarotkameraelement 3 sendet eine Infrarotbeleuchtung bzw. einen Infrarotblitz 18 aus, welcher vom Infrarotlicht reflektierenden Marker 14 als reflektiertes Infrarotlicht 20 in Richtung der Infrarotkameraelemente 3 zurückgeworfen wird. Aufgrund der definierten Beabstandung mit Abstand d sowie einer definierten Winkelanordnung α der Infrarotkameraelemente 3 zueinander ist somit ein Raumpunkt unter Verwendung des Markers 14 relativ zur Positionsbestimmungsvorrichtung 10 bestimmbar. Jedes Infrarotkameraelement 3 vermag hierbei eine optische Achse 12 bestimmen, wobei sich die Position des Markers 14 im Raum als Schnittpunkt der optischen Achsen 12 bzw. optischen Strahlen darstellt.

Eine derartige Bestimmung mag gleichzeitig in Bezug auf jeden Infrarotmarker 14 durchgeführt werden, wonach sich eine definierte Ausrichtung und Position des ersten Positionsbestimmungselementes 6 anhand seiner Mehrzahl von Infrarotmarkern 14 im Raum ergibt. Aufgrund einer bekannten geometrischen Anordnung der Marker 14 bzw. Ausgestaltung des ersten Positionsbestimmungselementes 6 mag somit eine definierte Lage im Raum bestimmbar sein.

Das erste Positionsbestimmungselement 6 mag weiterhin definiert an einem weiteren Element, beispielsweise einer Visualisierungsvorrichtung 4, anbringbar sein, wodurch, bei bekannten geometrischen Abmaßen bzw. Verhältnissen, die Lage und Ausrichtung des weiteren Elementes im Raum bestimmbar ist. Eine derartige Bestimmung mag beispielsweise durch Computersystem 16 vorgenommen werden, welches letztendlich zweidimensionale Bilddaten von jedem Infrarotkameraelement 6 erhält und hieraus aufgrund der bekannten definierten Ausgestaltung des ersten Positionsbestimmungselementes 6 dessen Position im Raum berechnet. Das optische Trackingsystem bzw. die Positionsbestimmungsvorrichtung 10 mag somit eine Position einzelner Marker 14 hochgenau bestimmen.

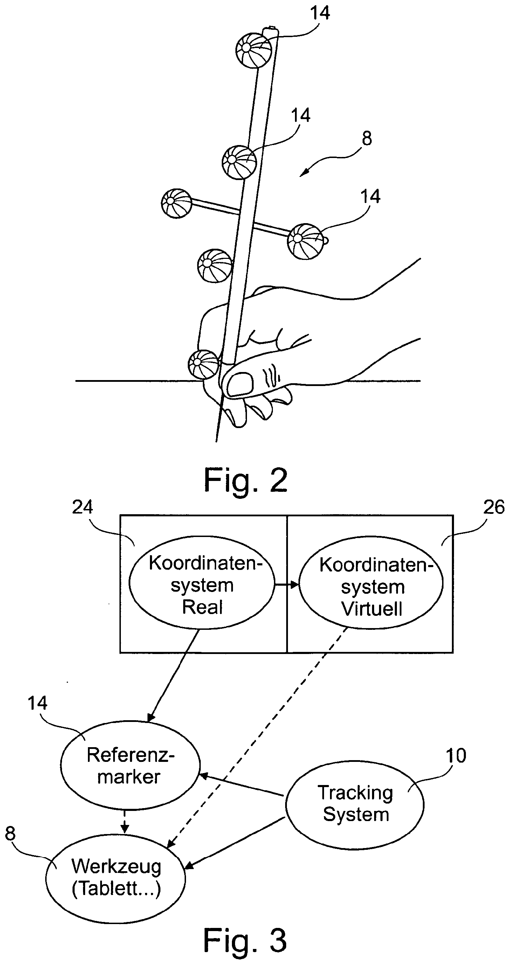

Weiter Bezug nehmend auf Figur 2 wird eine exemplarische Ausgestaltung eines zweiten Positionsbestimmungselementes gemäß der vorliegenden Erfindung dargestellt.

Das zweite Positionsbestimmungselement 8, exemplarisch ein Tastmarker, trägt in Figur 2 in definierter Beabstandung und Ausrichtung exemplarisch sechs Infrarotmarker 14. Durch die Anordnung und Ausrichtung der Infrarotmarker 14 im Raum lässt sich somit eine bekannte geometrische Ausgestaltung des zweiten Positionsbestimmungselementes, zum Beispiel die Spitze des zweiten Positionsbestimmungselementes, definiert im Raum festlegen. Somit mag die Spitze des zweiten Positionsbestimmungselementes 8 verwendet werden, um in einer Anordnung einzelne Punkte, beispielsweise im realen Modell, anzuzeigen und zu referenzieren. Bevorzugt weist das zweite Positionsbestimmungselement 8 weiterhin eine Eingabemöglichkeit auf, um Messwerte zum Beispiel zeitgleich im realen sowie virtuellen Modell zu erheben bzw. zu markieren. Ein derartiges zweites Positionsbestimmungselement 8 mag weiterhin an einem weiteren Werkzeug oder Element definiert anbringbar sein, um zu ermöglichen, das Werkzeug bzw. Element definiert zu referenzieren.

Weiter Bezug nehmend auf Figur 3 wird eine exemplarische Kalibrierung einer Anordnung zur kombinierten Darstellung eines realen und eines virtuellen Modells gemäß der vorliegenden Erfindung dargestellt.

Gefordert wird eine Relation zwischen einem realen Modell 24 und einem virtuellen Modell 26 herzustellen. Hierzu ist es notwendig, eine Relation zwischen dem Koordinatensystem des realen Modells und dem Koordinatensystem des virtuellen Modells herzustellen. Ein Trackingsystem 16 wird zunächst verwendet um eine Position bzw. Orientierung im Raum eines Werkzeuges 8 zu detektieren. Das Werkzeug 8 ist mit Markern 14 versehen um die Detektion zu ermöglichen. Z.B. mag das Werkzeug 8 gemäß Figur 2 verwendet werden, dessen Spitze in Bezug auf die Anordnung seiner Marker 14 einer eindeutigen Position und Orientierung in einem, zunächst beliebigen, Raum zugeordnet werden kann, welcher von der Positionsbestimmungsvorrichtung 10 abgedeckt werden kann. Nun kann eine Referenzierung bzw. eine Zuordnung zwischen realem Modell 24 und virtuellem Modell 26 derart erfolgen, dass z.B. identische Referenzpunkte im realen Modell 24 und im virtuellen Modell 26 angefahren werden, somit angezeigt werden. Im virtuellen Modell 26 mag dies mit einem virtuellen Werkzeug erfolgen. Weiterhin mögen die virtuellen Referenzpunkte vorgegeben sein, somit mag ein dediziertes Anzeigen im virtuellen Modell 26 nicht erforderlich sein. Im realen Modell 24 werden dieselben Referenzpunkte nun z.B. mit der referenzierten Spitze eines Werkzeuges 8 angezeigt, so dass nun eine Relation zwischen dem Raum bzw. zwischen dem sich darin befindlichem realen Modell 24 in Relation zur Positionsbestimmungsvorrichtung 14 herstellbar ist. In diesem Fall mag es notwendig sein, dass die Positionsbestimmungsvorrichtung 14, zumindest bis zu einer erneuten Kalibrierung, in Relation zum realen Modell 24 ortsfest bleibt. Auch ist denkbar, das reale Modell 24 selbst mit einem ersten Positionsbestimmungselement 6 zu versehen, z.B. dieses ortsfest am realen Modell 24 anzubringen. Somit mag insbesondere eine Relation von realem Modell 24 zu ersten Positionsbestimmungselement 8 festgelegt werden, welche unabhängig von einer Relation der Positionsbestimmungsvorrichtung 14 zum realen Modell 24 ist. Somit mag die Positionsbestimmungsvorrichtung 14 nach einer erfolgten Kalibrierung örtlich versetzt werden ohne dass hierdurch eine bekannte Relation von realem Modell 24 und erstem Positionsbestimmungselement 24 beeinflusst wird. Besonders geeignet ist dies im Falle eines starren realen Modells 24, welches somit keine relativ zueinander versetzbaren Elements aufweist. Alternativ mögen Einzelelemente des realen Modells jeweils individuell mit ersten Positionsbestimmungselement 6 versehen werden. In solch einem Fall mag es bevorzugt sein, unterscheidbare Positionsbestimmungselemente 6 zu verwenden, welche beispielsweise von der Positionsbestimmungsvorrichtung 10 bzw. einem daran angeschlossenen Computersystem 16 individuell detektiert und unterschieden werden können.

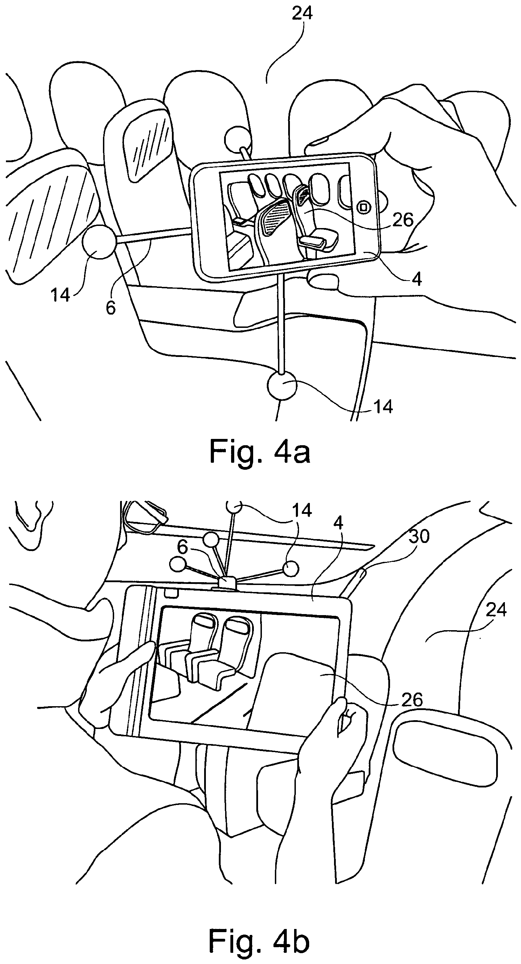

Weiter Bezug nehmend auf Figuren 4a, b werden exemplarische Ausgestaltungen einer Visualisierungsvorrichtung gemäß der vorliegenden Erfindung dargestellt.

In Figur 4a ist exemplarisch eine Visualisierungsvorrichtung 4 als Personal Digital Assistant (PDA) dargestellt. Die Visualisierungsvorrichtung 4 weist auf der dem Betrachter der Figur abgewandten Seite eine Informationsaufnahmevorrichtung 28, beispielsweise eine Videokamera, auf. Im Hintergrund von Figur 4a befindet sich ein reales Modell 24, hier exemplarisch eine Anordnung einer Sitzgruppe in einem Flugzeug. Die Visualisierungsvorrichtung 4 ist mit einer Mehrzahl von Markern 14 versehen, welche gemeinsam ein erstes Positionselement 6 darstellen, das definiert an der Visualisierungsvorrichtung 4 angebracht ist. Auf der Anzeige der Visualisierungsvorrichtung 4 dargestellt ist eine Aufnahme der Informationsaufnahmevorrichtung 28 des realen Modells 24, überlagert mit einem virtuellen Modell 26. Verschiedene Parameter mögen nun im virtuellen Modell 26 verändert werden, beispielsweise die Farbgebung eines Elementes des realen Modells 24, wodurch sich für einen Betrachter der Gesamteindruck aus virtuellem Modell 26 und realem Modell 24 anpassen lässt.

Figur 4b zeigt ein vergleichbares Szenario zu Figur 4a, hier jedoch unter Verwendung einer Visualisierungsvorrichtung 4, beispielsweise eines portablen Computers, welche ein größeres Format gegenüber der Visualisierungsvorrichtung 4 der Figur 4a aufweist. Auch an der Visualisierungsvorrichtung 4 der Figur 4b ist definiert ein erstes Positionsbestimmungselement 6 mit einer Mehrzahl von Markern 14 angebracht. Die Visualisierungsvorrichtung 4 weist weiterhin ein Kommunikationselement 30, hier beispielsweise eine Antenne, auf, welche einerseits Daten zum Beispiel des virtuellen Modells zur Darstellung empfangen, andererseits Information, welche eine Veränderung des virtuellen Modells 26 betreffen, z.B. an ein Zentralrechensystem mit angeschlossener Datenbank zurückmelden vermag.

Beide Visualisierungsvorrichtungen 4 gemäß Figuren 4a, b zeigen somit ein virtuelles Fenster in eine reale Umgebung, welche Darstellung sich gezielt anpassen lässt, um einen veränderten Bildeindruck zu vermitteln.

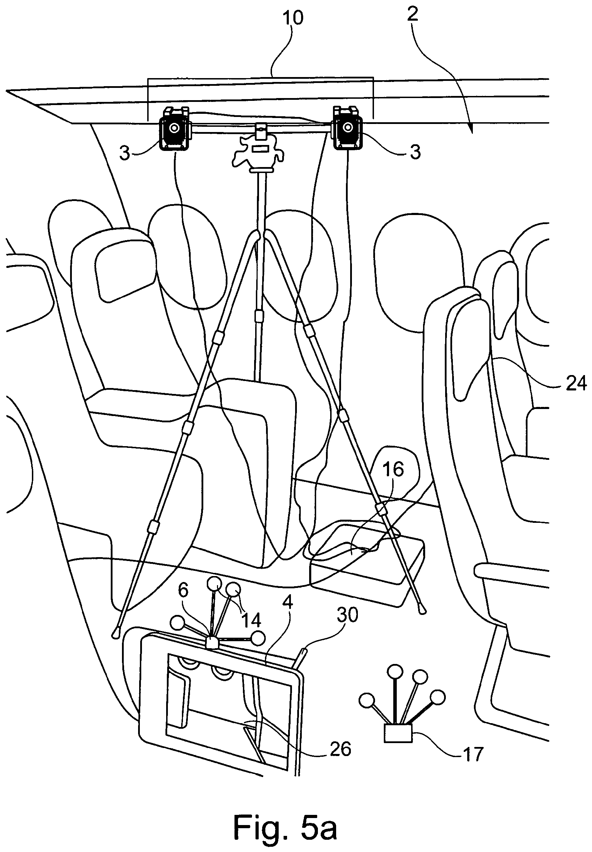

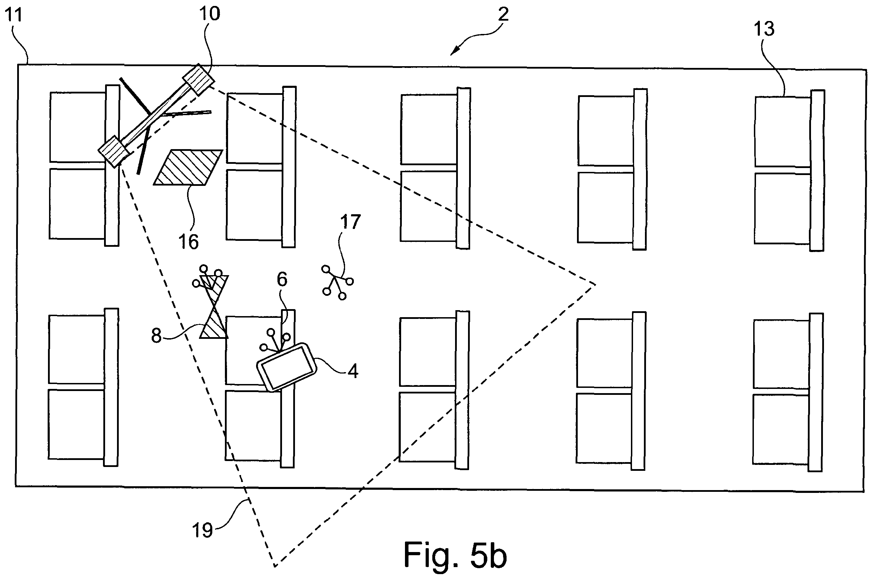

Weiter Bezug nehmend auf Figuren 5a,b wird eine exemplarische Ausgestaltung einer Anordnung zur kombinierten Darstellung eines realen und eines virtuellen Modells gemäß der vorliegenden Erfindung dargestellt.

In Figur 5a ist eine 3D-Komplettübersicht einer Anordnung zur kombinierten Darstellung eines realen und eines virtuellen Modells dargestellt. Eine Positionsbestimmungsvorrichtung 10 ist auf einem Dreibein montiert und deckt unter Verwendung der beiden Infrarotkameraelemente 3 einen Raumbereich im realen Modell 24 ab. In Figur 5a ist weiterhin die Visualisierungsvorrichtung 4 gemäß Figur 4b dargestellt. Ein Computersystem 16 ist an die Infrarotkameraelemente 3 angebunden und mag weiterhin eine Funkverbindung unter Verwendung des Kommunikationselements 30 mit der Visualisierungsvorrichtung 4 aufweisen.

Somit mögen Untersuchungen zu Variantendarstellung und Zulassbarkeit in einer kombinierten real virtuellen Umgebung durchgeführt werden. Eine Kalibrierung von erstem Positionsbestimmungselement 8 mit seiner zugehörigen Relation zu Visualisierungsvorrichtung 4 mag notwendig sein, insbesondere unter Berücksichtigung von Ausrichtung und Orientierung der Informationsaufnahmevorrichtung 28 der Visualisierungsvorrichtung 4.

Ein Referenzmarker 17 wird verwendet die Relation zwischen realem und virtuellem Koordinatensystem aufzubauen. Die Position/Orientierung des Referenzmarkers 17 ist sowohl im realen Modell 24 als auch im virtuellen Modell 26 bekannt, daher ermöglicht er eine einfache Abbildung der beiden Koordinatensysteme aufeinander. Es können durchaus mehrere Referenzmarker 17, auch zeitgleich, in einem solchen System genutzt werden. Der Referenzmarker ist bevorzugt orts- und orientierungsfest an dem realen Modell angebracht.

Weiter bezugnehmend auf Figur 5b wird die Anordnung gemäß Figur 5a als Aufsicht dargestellt.
Eine Positionsbestimmungsvorrichtung 10 ist exemplarisch in einer Flugzeugkabine 2 angeordnet und an Computersystem 16 angeschlossen. Monumente bzw. Flugzeugsitzgruppen 13 sind ebenfalls in der Flugzeugkabine 2 angeordnet. Im Sichtbereich 19 der Positionsbestimmungsvorrichtung 10 sind weiterhin ein Werkzeug mit zweitem Positionsbestimmungselement 8, eine Visualisierungsvorrichtung 4 mit erstem Positionsbestimmungselement 6 sowie ein Referenzmarker 17 angeordnet.

Ein exemplarischer systematischer Ablauf mag wie nachfolgend skizziert erfolgen. Die Positionserfassungsvorrichtung 10 lokalisiert sich selbst via Referenzmarker 17 innerhalb des virtuellen Modells 26, dessen Position im virtuellen Modell 26 bekannt ist. Sollten mehrere Referenzmarker 17 im Sichtbereich 19 erfasst werden, mag die Lokalisierung entsprechend optimiert, somit deren Genauigkeit gesteigert werden. Die Positionserfassungsvorrichtung 10 mag nun die Position und/oder Orientierung von Werkzeugelement 8 bzw. der Visualisierungsvorrichtung 4 im realen Modell 24 erfassen, um diese somit auch innerhalb des virtuellen Modells 26 zu lokalisieren bzw. abzubilden. Dies mag beispielsweise durch Hintereinanderschalten von Transformationen und Multiplikationen erfolgen. Werkzeugelement 8 mag selbstständig mit dem virtuellen Modell 26 kommunizieren, im Falle der Visualisierungsvorrichtung 4 mag dies unter Verwendung eines Graphical User Interfaces (GUI) erfolgen, beim Werkzeugelement 8 auch mittels Tasten oder anderen Sensoren.

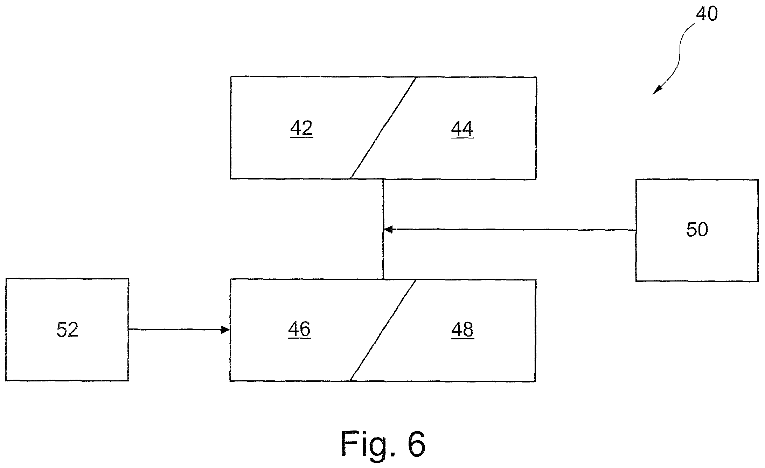

Weiter Bezug nehmend auf Figur 6 wird eine exemplarische Ausgestaltung eines Verfahrens zur Simulation eines virtuellen Modells im Kontext eines realen Modells gemäß der vorliegenden Erfindung dargestellt.

Figur 6 zeigt Verfahren 40 zur Simulation eines virtuellen Modells im Kontext eines realen Modells, welches gleichzeitig oder abfolgend das Bereitstellen 42 eines referenzierten realen Modells sowie eines realen Werkzeugelementes (8) sowie Bereitstellen 44 eines referenzierten virtuellen Modells sowie eines virtuellen Werkzeugelementes (9) aufweist. Das reale Werkzeugelement (8) und das virtuelle Werkzeugelement (9) sind hierbei logisch-funktional einander zugeordnet.

Nachfolgend mag das virtuelle Modell 26 unter Verwendung der Referenz des realen Modells 24 dargestellt 46 werden, wobei weiterhin eine Relation zwischen realem Modell 24 und virtuellem Modell 26 erstellt 50 werden mag. Andererseits mag auch ein Gesamtmodell aus zumindest einem Teil eines realen Modells 24 und zumindest einem Teil eines virtuellen Modells 26 dargestellt 48 werden. Der zumindest eine Teil des realen Modells 24 und der zumindest eine Teil des virtuellen Modells 26 mögen hierbei zumindest teilweise überlagernd darstellbar sein. Ein Parameter des realen Modells mag ermittelt 52 werden unter Verwendung des realen Werkzeugelementes (8), wobei das virtuelle Modell 26 unter Verwendung des Parameters veränderbar ist. Andererseits mag direkt in die Parameter des virtuellen Modells 26 eingegriffen werden können, um dieses zu verändern.

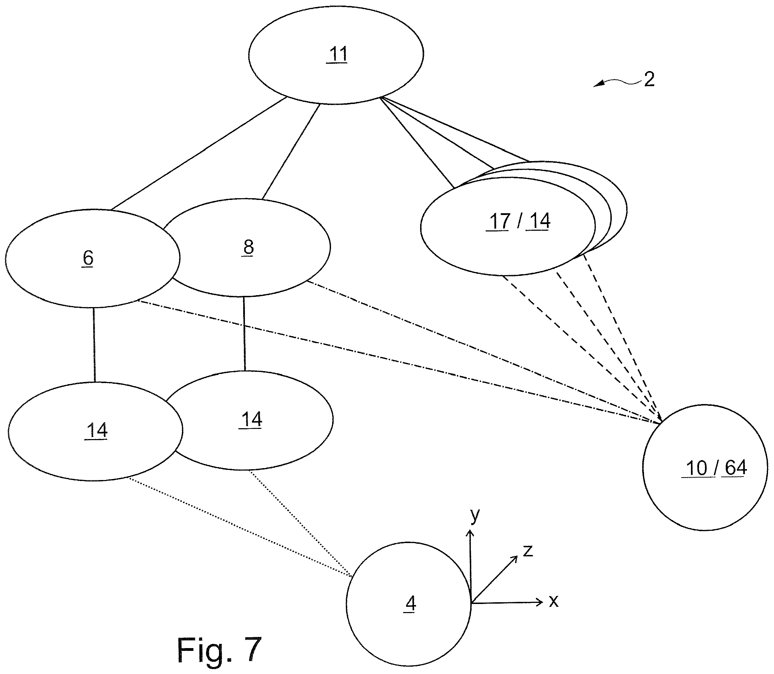

Weiter Bezug nehmend auf Fig. 7 ist eine exemplarische schematische Darstellung der Anordnung zur Verifikation eines realen Modells und zur Verwendung eines virtuellen Modells gemäß der vorliegenden Erfindung dargestellt.

Anordnung 2 weist eine Flugzeugkabine 11 bzw. Flugzeugstruktur 11 auf, an welcher exemplarisch ein erstes Positionsbestimmungselement 6 sowie ein zweites Positionsbestimmungselement 8 angebracht ist. Weiterhin ist Referenzmarker 17 an Flugzeugstruktur 11 angebracht. Die durchgezogenen Linien geben hierbei eine feste bzw. definierte Anbindung wieder, beispielsweise werden die Positionsbestimmungselemente 6, 8 bzw. der Referenzmarker 17 fest an der Flugzeugstruktur angebracht, zum Beispiel verschraubt.

Erstes und zweites Positionsbestimmungselement 6, 8 weisen einzelne Markerelemente 14 auf, welche eingerichtet sind, das erste Positionsbestimmungselement 6 und das zweite Positionsbestimmungselement 8 in Bezug auf Position und/oder Orientierung eindeutig zu bestimmen. Markerelemente 14 können hierbei exemplarisch passive Reflektoren oder aktiv leuchtende Elemente, z.B.im IR-Bereich des Spektrums, sein.

Eine Visualisierungsvorrichtung 4 mag ausgebildet sein und die eigene Pose in Relation zu den Markern 14 des ersten und zweiten Positionsbestimmungselementes 6, 8 feststellen zu können, z.B. durch Positionsbestimmungsvorrichtung 10. Hierdurch ist eine Position der Visualisierungsvorrichtung 4 im Raum in Bezug auf erstes und zweites Positionsbestimmungselement 6, 8 möglich. Gestrichelte Linien geben hierbei keine feste Verbindung wieder. Visualisierungsvorrichtung 4 ist somit in Relation zu den Markern 14 im realen Modell 24 der Flugzeugkabine 11 bewegbar. Eine aktuelle Position und/oder Orientierung ist jedoch jederzeit von Visualisierungsvorrichtung 4 bestimmbar.

Zu beachten ist, dass jedes Element, das lokalisierbar ist, einen Markerverbund, somit eine Mehrzahl von Markern 14 aufweist, um im Raum auffindbar zu sein. Die einzelnen Marker 14 eines Elementes bilden hierbei einen Verbund durch den Sie räumlich erkannt werden können. Um eine Mehrzahl von Elementen gleichzeitig wahrnehmen zu können, müssen Markerverbünde von unterschiedlichen Elementen individuell und unterscheidbar ausgestaltet sein. Z.B. sollte die geometrische Form der Markerverbünde deshalb nach Möglichkeit nicht durch Translation, Rotation oder Skalierung ineinander überführbar sein, da sonst eine Mehrzahl von Elementen nicht eindeutig im Raum durch ein optisches System wahrnehmbar bzw. zumindest nicht unterscheidbar wären.

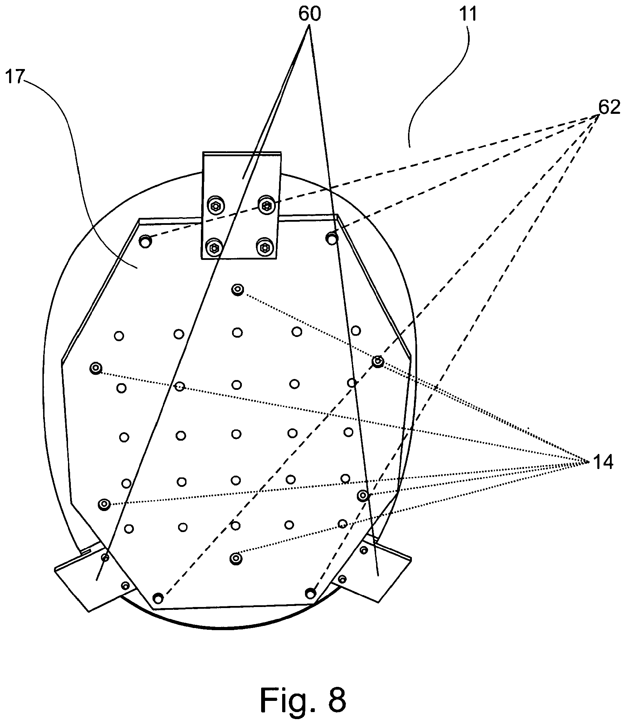

Denkbar ist auch, dass die Marker 14 als aktive Elemente ausgebildet sind, z.B. LEDs, insbesondere IR-LEDs. Diese Marker können neben oder alternativ zu einer räumliche Anordnung eine vorbestimmte und individuelle Aktivität, z.B. Ein/AusZustand, Blinkfrequenz, Blinkmuster und/oder Intensität aufweisen. Hierzu mag eine Ansteuerung bzw. Synchronisation der Marker notwendig sein. Dies ist insbesondere notwendig wenn die Marker keine räumlich eindeutige Anordnung haben. z.B. ist die Anordnung der Marker in Fig. 8 im Wesentlichen spiegel- und rotationssymmetrisch dargestellt. Demgegenüber verwendet das System aus Figur 1b und 2 exemplarisch räumlich eindeutige retroreflektive Marker, muss also nicht über synchronisierte Zeitpunkte die Marker 14 bzw. LEDs identifizieren, sondern kann alle retroreflektiven Marken zeitgleich erfassen.

Der Markerverbund muss nicht auf einem einzelnen Referenztarget aufgebracht sein, es muss nur möglich sein, die Position jedes Marker durch das Einmessen exakt zu bestimmen. Hierfür wäre es also auch denkbar, die Marker einzeln einzubringen, einzumessen, z.B. per Lasermesssystem bzw. Kalibierungssystem 64,und erst in der Gesamtheit als Markerverbund zu interpretieren.

Erstes Positionsbestimmungselement 6 und zweites Positionsbestimmungselement 8 mögen an zuvor definierten Positionen im/am realen Modell 24 befestigbar sein, welche gleichfalls als entsprechende Befestigungspunkte im virtuellen Modell 26 bekannt sind. In diesem Fall ist eine Registrierung von erstem Positionsbestimmungselement 6 und zweitem Positionsbestimmungselement 8 in Relation zur Flugzeugkabine 11 nicht notwendig. Im Falle, dass ein weiteres Positionsbestimmungselement, zum Beispiel Referenzmarker 17, an einer im virtuellen Modell 26 nicht näher bezeichneten Stelle am des realen Modells 24 angebracht wird, mag eine Offline-Registrierung der Position von Referenzmarker 17 notwendig sein. Hierzu mag beispielsweise die Positionsbestimmungsvorrichtung 10 zusammen mit Kalibrierungsvorrichtung 64 verwendet werden.

Referenzmarker 17 mag an beliebiger Stelle an/in der Flugzeugkabine 11 angebracht werden. Nachfolgend werden unter Verwendung der Kalibrierungsvorrichtung 64 bekannte Kalibrierungspunkte 62 des Referenzmarkers 17 sowie der Flugzeugkabine 11 angefahren und hierdurch eine feste Relation zwischen Referenzmarker 17 und Flugzeugkabine 11 bzw. Flugzeugstruktur 11 hergestellt. Hierzu mögen einerseits bekannte Kalibrierungspunkte der Flugzeugstruktur 11 verwendet werden, welche dergestalt im virtuellen Modell bekannt sind oder aber es mögen beispielsweise erstes bzw. zweites Positionsbestimmungselement 6, 8 aufgrund ihrer ebenfalls bekannten Position in der Flugzeugkabine 11 verwendet werden.

Weiter Bezug nehmend auf Fig. 8 ist eine exemplarische Ausgestaltung eines Referenzmarkers gemäß der vorliegenden Erfindung dargestellt.

Referenzmarker 17 ist unter Verwendung von Klammern 60 an der Flugzeugstruktur 11 fest angebracht. Aufgrund der großflächigen Anbringung und Ausgestaltung des Referenzmarkers 17 ist eine bevorzugte Sichtbarkeit in der Flugzeugkabine 11 gewährleistet. Referenzmarker 17 weist Befestigungsmöglichkeiten für (passive) Markerelemente 14 oder aber auch aktive Markerelemente 14 auf. Diese mögen derart definiert ausgestaltet sein, um, aufgenommen mit einer Visualisierungsvorrichtung 4 bzw. einer Positionsbestimmungsvorrichtung 10, eine definierte Position und/oder Orientierung im Raum bereitzustellen. Kalibrierungspunkte 62 sind auf dem Referenzmarker 17 vorgesehen, um ihn unter Verwendung einer Kalibrierungsvorrichtung 64 räumlich festzulegen und in Relation zum virtuellen Modell 26 und realen Modell 24 zu setzen.

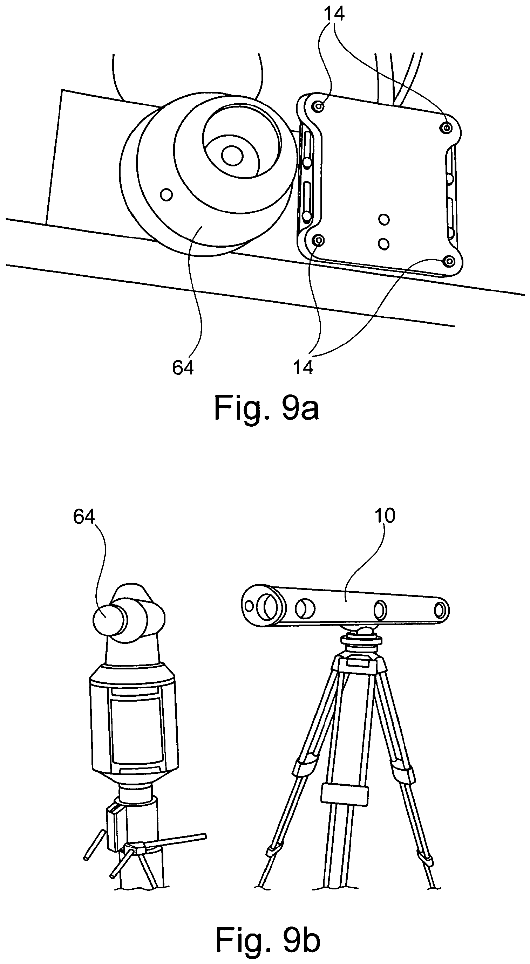

Weiter Bezug nehmend auf Fig. 9a,b werden exemplarische Ausgestaltungen einer Positionsbestimmungsvorrichtung mit zugehöriger Kalibrierungsvorrichtung gemäß der vorliegenden Erfindung dargestellt.

In Fig. 9b dargestellt ist Positionsbestimmungsvorrichtung 10 sowie Kalibrierungsvorrichtung 64.

Markerelemente 14 werden fest im Flugzeug unter Verwendung des Referenzmarkers 17 installiert. Dies mag einerseits über das Klammersystem des Referenzmarkers 17 gemäß Fig. 8 erfolgen oder aber über spezielle Adapter, welche es einfach ermöglichen, die Markerelemente 14 definiert und fest mit vorbestimmter Pose aufzunehmen. Hierdurch können die Marker 14 leicht entfernt und wieder angebracht werden, falls dies ein Produktionsschritt erfordert, ohne die Position und Orientierung der Marker 14 zu verändern, und somit ohne eine erneute Registrierung auszulösen. Auch mag der Referenzmarker 17 selbst derart ausgestaltet sein, dass er, z.B. von einem Grundträger trennbar ist und nachträglich wieder, wie zuvor, definiert angebracht werden kann.

Die Position und Orientierung eines Referenzmarkers 17 mag auf verschiedene Weise gemessen bzw. festgelegt werden. Einerseits mag ein Offline-Messsystem als auch ein Online-Messsystem verwendet werden.

Der Referenzmarker 17 weist mehrere Markierungen auf, Kalibrierungspunkte 62, um eine Registrierung in Relation zur Flugzeugstruktur 11, insbesondere eine Transformation zwischen Flugzeug und Referenzmarker 17, zu registrieren. Auch weist Referenzmarker 17 Marker 14 auf, um diese von einem Online-Messsystem bzw. Tracking-System erfassen zu können, wie beispielsweise Visualisierungsvorrichtung 4.

Unter Verwendung eines hochpräzisen Offline-Messsystems können spezielle Messvorgänge durchgeführt werden, welche vordefiniert in Bezug auf ein reales Modell 24 in Verbindung mit einem virtuellen Modell 26 sind, welche nachfolgend offline analysiert werden mögen. Ein Referenzmarker 17 zur Verwendung in einem Offline-System mag deshalb insbesondere fest positioniert werden müssen in Bezug auf die Flugzeugstruktur 11, um Messfehler zu vermeiden.

Weiterhin mögen Vibrationen der Flugzeugstruktur 11 gering gehalten werden müssen, so dass insbesondere eine Produktion in einem solchen Vibrationszustand nach Möglichkeit pausiert werden sollte.

Um den Referenzmarker 17 in Relation zur Flugzeugstruktur 11 definiert festzulegen, werden Kalibrierungspunkte 62 verwendet. Zumindest drei Punkte werden benötigt, um eine Transformation zwischen dem Offline-Messsystem, beispielsweise bestehend aus Positionsbestimmungsvorrichtung 10 zusammen mit Kalibrierungsvorrichtung 64, und dem virtuellen Koordinatensystem des virtuellen Modells festzulegen. Hierdurch werden Messungen von Positionen und Längen im selben Koordinatensystem durchgeführt und mögen somit direkt ausgegeben und weiterverarbeitet werden. Werden mehr als drei Kalibrierungspunkte verwendet, mag sich der Registrierungsfehler zwischen Offline-Messsystem und Flugzeugstruktur 11 verringern. Vibrationen während und nach der Registrierung invalidieren die Registrierung aufgrund einer möglichen Positions- und/oder Orientierungsverschiebung des, nicht fest mit der Flugzeugstruktur 11 verbundenen, Offline-Messsystems, z.B. Positionsbestimmungsvorrichtung 10, was in einer erneuten Registrierungsprozedur resultieren mag.

Ein solches hochpräzises Offline-Messsystem mag gewöhnlich dazu verwendet werden, die Messung eines einzigen Parameters durchzuführen, insbesondere bei großen zu überbrückenden Räumen. Ein entsprechendes Offline-Messsystem mag beispielsweise ein Lasermesssystem sein. Die Kalibrierungsvorrichtung 64 mag auch ein solches Lasermessystem aufweisen. Zur Registrierung des Offline-Messsystems, insbesondere in Bezug auf Referenzmarker 17, mag eine Registrierung des Referenzmarkers 17 durch Vermessung, beispielsweise mittels des Lasermesssystems oder des Kalibierungsvorrichtung 64, von Referenzpunkten im Flugzeug sowie Kalibrierungspunkten 62 des Referenzmarkers 17 erfolgen.

Insbesondere mag eine Positionsbestimmung durch das Lasermesssystems aufgrund von im Flugzeug festgelegten Referenzpunkten erfolgen mit nachfolgender Kalibrierung des Referenzmarkers 17. In anderen Worten wird hierbei zunächst die Position des Lasermesssystems in Relation zur Flugzeugstruktur festgelegt und nachfolgend die Relation von Referenzmarker 17 zum Lasermesssystem. Aufgrund der zugehörigen Beziehung ist somit eine Relation zwischen Flugzeugstruktur und Referenzmarker 17 darstellbar.

Figur 9a stellt eine weitere exemplarische Ausgestaltung eines Referenzmarkers 17 dar. Das Lasertarget 65 mag vom Laser der Kalibierungsvorichtung 64 erkannt werden. Die Markeranordnung, exemplarisch bestehend aus 4 aktiven LED-Markern 14, mag von der Positionsbestimmungsvorrichtung 10 erkannt werden. Um einen solchen Referenzmarker 17 in das reale Modell, z.B. ein Flugzeug, einzubringen mögen zumindest 3 Punkte auf dem Referenzmarker 17 vom Laser der Kalibierungsvorichtung 64 gemessen werden. Hierzu mögen beispielsweise den Kalibierungspunkten 62 gemäß Fig. 8 vergleichbare Kalibierungspunkte verwendet werden, die in Fig. 9a jedoch nicht eingezeichnet sind. Mehr als 3 Kalibierungspunkte 62 ermöglichen hierbei eine Überbestimmung zur Fehlerminimierung.

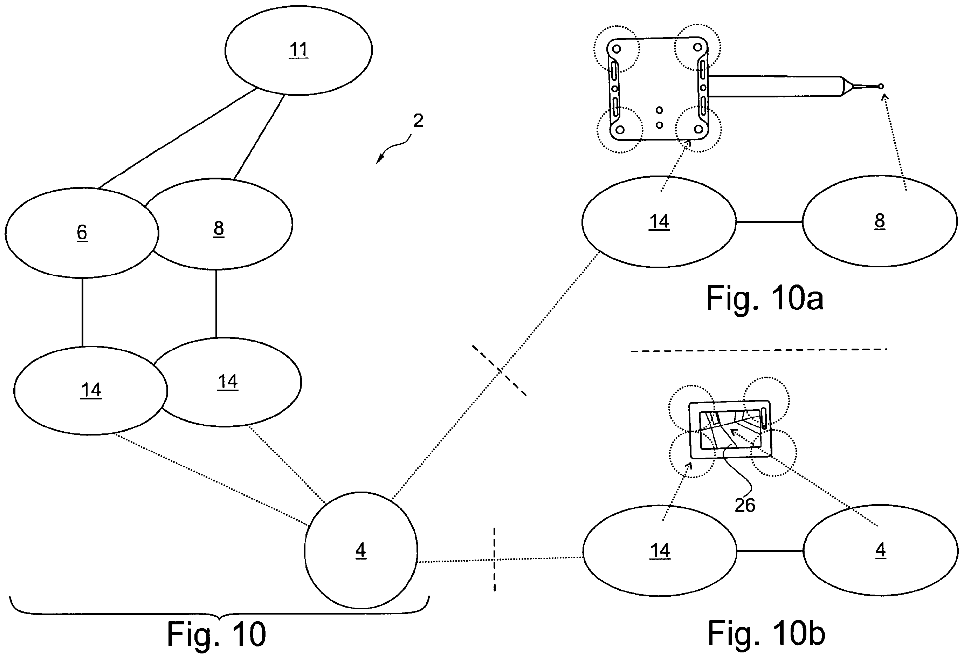

Weiter Bezug nehmend auf Fig. 10,a,b ist eine exemplarische schematische Darstellung der Anordnung zur Verifikation eines realen Modells unter Verwendung eines virtuellen Modells gemäß der vorliegenden Erfindung dargestellt.

Fig. 10 entspricht hierbei im Wesentlichen den entsprechenden Elementen der Fig. 7.

Das Online-Tracking-System weist im Weiteren als reales Werkzeugelement 8 eine Prüfspitze auf. Die Prüfspitze weist Marker 14 auf. Hierdurch lässt sich im Wesentlichen eine Position der Prüfspitze im Raum sowie eine zugehörige Orientierung festlegen. Weiterhin weist das System Visualisierungsvorrichtung 4 auf, an welcher gleichfalls Marker 14 definiert angebracht sind. Hierdurch lässt sich eine Position und/oder Orientierung von Visualisierungsvorrichtung 4 im Raum bestimmen. Auch mag Visualisierungsvorrichtung 4 über eine Informationsaufnahmevorrichtung verfügen, welche ihrerseits eingerichtet ist, zum Beispiel erstes Positionsbestimmungselement 6 zu detektieren und somit eine Position der Visualisierungsvorrichtung 4 im Raum zu bestimmen.

Die Pose der Visualisierungsvorrichtung 4 mag mittels Positionsbestimmungsvorrichtung 10 detektierbar sein. Sowohl im Falle der externen Lokalisierung der Visualisierungsvorrichtung 4 durch Positionsbestimmungsvorrichtung 10 als auch Eigen-Posebestimmung der Visualisierungsvorrichtung 4 ist deren Position und/oder Orientierung im Raum und somit in Relation zur Flugzeugstruktur 11 bzw. zur Flugzeugkabine 11 bekannt. Hierdurch lässt sich ein virtuelles Modell 26 auf einem Display der Visualisierungsvorrichtung 4 abbilden, entsprechend der vorherrschenden Pose.

Ein virtuelles Werkzeugelement 9 mag sich in das virtuelle Modell 26 einblenden lassen, welches beispielsweise ein virtuelles Pendant zum realen Werkzeugelement 8 bzw. dessen Prüfspitze darstellt. Somit mag sich beispielsweise im virtuellen Modell 26 mit virtuellem Werkzeugelement 9 eine Messung vornehmen lassen und diese im realen Modell 24 mit realem Werkzeugelement 8 überprüfen. Beide Messwerte können nachfolgend in Reaktion zueinander gesetzt werden, um beispielsweise eine Fertigungstoleranz festzustellen.

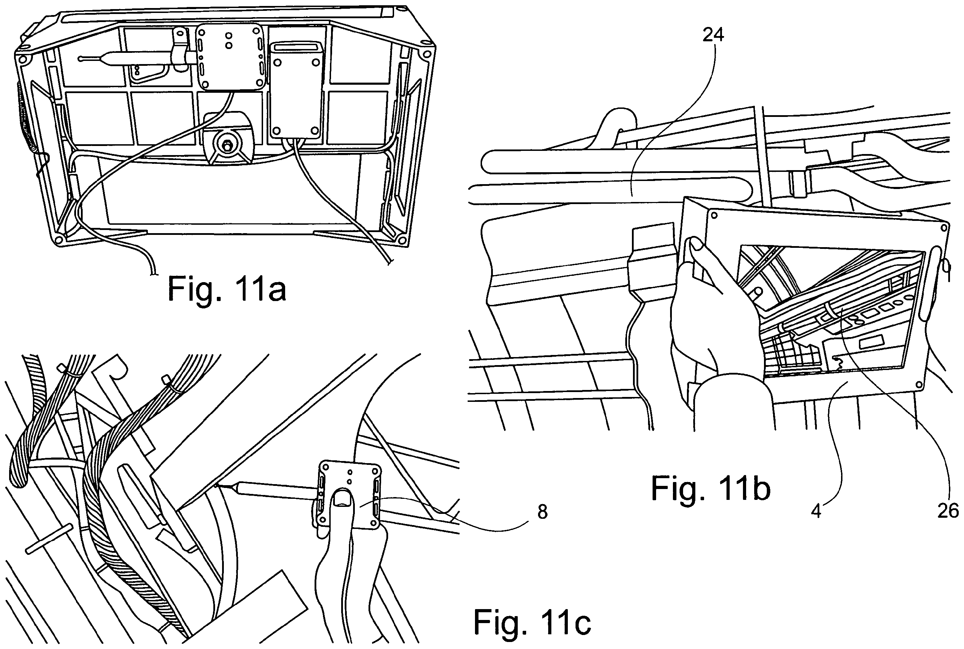

Weiter Bezug nehmend auf Fig. 11a-c wird ein exemplarisches Anwendungsszenario der Anordnung gemäß der vorliegenden Erfindung dargestellt.

Exemplarisch gezeigt in Fig. 11a ist eine rückseitige Ansicht der Visualisierungsvorrichtung 4. Hierbei ist das zweite Positionsbestimmungselement 8 bzw. reale Werkzeugelement 8 per Kabel an die Visualisierungsvorrichtung 4 angebunden. Die Kabelanbindung mag exemplarisch zur Ansteuerung bzw. Synchronisation aktiver Markerelemente 14 bereitgestellt sein.

In Fig. 11b dargestellt ist die Wiedergabe eines virtuellen Modells 26, abhängig von Position und/oder Orientierung der Visualisierungsvorrichtung 4, zu welchem zugehörig das reale Modell 24 im Hintergrund sichtbar ist. Im Falle, dass die Visualisierungsvorrichtung eine Informationsaufnahmevorrichtung aufweist, ist eine überlagerte Darstellung von realem Modell 24 und virtuellem Modell 26 auf dem Display der Visualisierungsvorrichtung 4 denkbar. In das Abbild mögen somit einzelne Elemente des virtuellen Modells 26 eingeblendet werden, um deren Vorhandensein und korrekte Anbringung im realen Modell 24 überprüfen zu können.

In Fig. 11c ist reales Werkzeugelement 8 verwendet, um eine Funktion auszuführen bzw. einen Parameter zu bestimmen. Dies mag beispielsweise die Position der Schlauchanbindung, wie in Fig. 11c dargestellt, sein, welche mit der vorgegebenen Position im virtuellen Modell 26 verglichen werden mag, um somit beispielsweise Fertigungstoleranzen darzustellen oder eine Fehlproduktion zu erkennen.

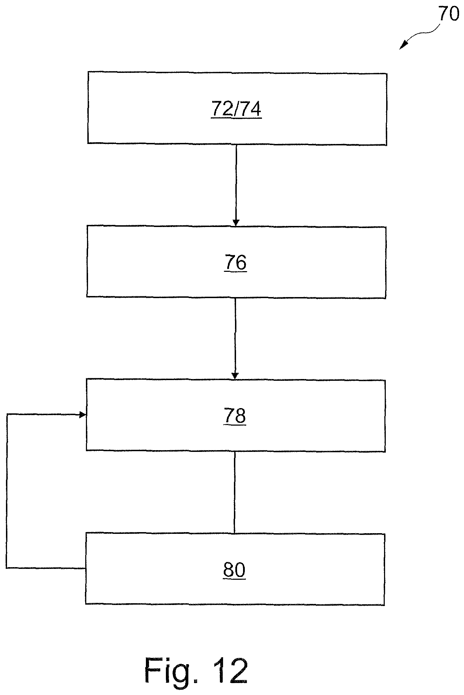

Weiter Bezug nehmend auf Fig. 12 wird eine exemplarische Ausgestaltung des Verfahrens zur Verifikation eines realen Modells unter Verwendung eines virtuellen Modells gemäß der vorliegenden Erfindung dargestellt.

Fig. 12 zeigt Verfahren 70 zur Verifikation eines realen Modells unter Verwendung eines virtuellen Modells, aufweisend die Schritte Bereitstellen 72 eines referenzierten realen Modells 24 sowie eines realen Werkzeugelementes sowie Bereitstellen 74 eines referenzierten virtuellen Modells 26, wobei eine Funktion des realen Werkzeugelementes 8 einer Funktion im virtuellen Modell 26 logisch funktional zuordenbar ist. Nachfolgend wird eine Relation zwischen realem Modell 24 und virtuellem Modell 26 erstellt 76. Diese Relation mag eine der zuvor beschriebenen Registrierungsvarianten sein.

Nun mag ein Parameter des realen Modells unter Verwendung des realen Werkzeugelementes 8 ermittelt werden 78 und mit einem dementsprechenden Parameter der Funktion im virtuellen Modell 26 verglichen werden 80.

Schritte 78 und 80 mögen hierbei wiederholend durchgeführt werden, im Rahmen des Betriebs der erfindungsgemäßen Anordnung.

Ergänzend sei darauf hingewiesen, dass "aufweisend" oder "umfassend" keine anderen Elemente oder Schritte ausschließt und dass "eine" oder "ein" keine Vielzahl ausschließt. Ferner sei daraufhingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

### Bezugszeichenliste

- 2: Anordnung
- 3: Infrarotkameraelement
- 4: Visualisierungsvorrichtung
- 6: erstes Positionsbestimmungselement
- 8: zweites Positionsbestimmungselement/ reales Werkzeugelement
- 9: virtuelles Werkzeugelement
- 10: Positionsbestimmungsvorrichtung
- 11: Flugzeugkabine/Flugzeugstruktur
- 12: optische Achse / berechnete optische Achse
- 13: Sitzgruppe/Monument
- 14: Marker / Infrarotmarker
- 15: Messpunkte
- 16: Computersystem
- 17: Referenzmarker
- 18: Infrarotbeleuchtung
- 19: Sichtfeld
- 20: reflektiertes Infrarotlicht
- 22: definierte Position
- 24: reales Modell
- 26: virtuelles Modell / überlagertes Modell
- 28: Informationsaufnahmevorrichtung
- 30: Kommunikationselement
- 40: Verfahren zur Simulation eines virtuellen Modells im Kontext eines realen Modells
- 42: SCHRITT: Bereitstellen eines referenzierten realen Modells
- 44: SCHRITT: Bereitstellen eines referenzierten virtuellen Modells
- 46: SCHRITT: Darstellen des virtuellen Modells unter Verwendung der Referenz des realen Modells
- 48: SCHRITT: Darstellen eines Gesamtmodells
- 50: SCHRITT: Erstellen einer Relation zwischen realem Modell und virtuellem Modell
- 52: SCHRITT: Ermitteln eines Parameters
- 60: Klammern
- 62: Kalibrierungspunkte
- 64: Kalibrierungsvorrichtung/Messsystem
- 65: Kalibierungstarget/Lasertarget
- 70: Verfahren zur Verifikation eines realen Modells unter Verwendung eines virtuellen Modells
- 72: SCHRITT: Bereitstellen eines referenzierten realen Modells sowie eines realen Werkzeugelementes
- 74: SCHRITT: Bereitstellen eines referenzierten virtuellen Modells
- 76: SCHRITT: Erstellen einer Relation zwischen realem Modell und virtuellem Modell
- 78: SCHRITT: Ermitteln eines Parameters des realen Modells
- 80: SCHRITT: Vergleichen des Parameters

## Patentansprüche

1. Anordnung (1) zur Verifikation eines realen Modells einer Flugzeugstruktur unter Verwendung eines virtuellen Modells, aufweisend
ein reales Modell (24), aufweisend ein reales Koordinatensystem, in dem ein erstes Positionsbestimmungselement (6) definiert angebracht ist und ein reales Werkzeugelement (8) angeordnet ist;
ein virtuelles Modell (26), aufweisend ein virtuelles Koordinatensystem mit einem virtuell angeordnetem Werkzeugelement (9); eine Visualisierungsvorrichtung (4) zur überlagerten Darstellung des realen Modells (24) und des virtuellen Modells (26);
eine Kamera, welche an der Visualisierungsvorrichtung (4) angebracht ist, und dazu ausgeführt ist, ein Abbild des realen Modells aufzunehmen und auf der Visualisierungsvorrichtung (4) darzustellen;
eine Positionsbestimmungsvorrichtung (10);
wobei die Positionsbestimmungsvorrichtung (10) eingerichtet ist, die Position/Orientierung des ersten Positionsbestimmungselementes (6) im realen Modell (24) zu bestimmen und/oder definiert festzulegen; wobei mittels der Positionsbestimmungsvorrichtung relativ zum ersten Positionsbestimmungselement (6) eine Position und/oder Orientierung des realen Werkzeugelementes (8) im realen Modell (24) bestimmbar ist;
wobei eine Funktion des realen Werkzeugelementes (8) im realen Modell (24) auslösbar ist; ein Sensor, wobei ein Erfassen der Funktion durch den Sensor erfolgt; wobei die Funktion des realen Werkzeugelementes (8) durch die Visualisierungsvorrichtung auf die Funktion des virtuellen Werkzeugelements im virtuellen Modell (24) abbildbar ist, indem die Funktionen in identischer Weise implementiert sind; und
wobei die Funktion des realen Werkzeugelementes (8) im realen Modell (24) und die durch die Visualisierungsvorrichtung abgebildete Funktion im virtuellen Modell (26) im Wesentlichen identisch sind.

2. Anordnung gemäß Anspruch 1,
wobei durch die identische Funktion im realen Modell (24) und der abgebildeten Funktion im virtuellen Modell (26) die reale Funktion unter Verwendung der abgebildeten Funktion überprüfbar ist.

3. Anordnung gemäß zumindest einem der vorhergehenden Ansprüche,
wobei die Position und/oder Orientierung des realen Werkzeugelementes (8) im virtuellen Modell (24) unter Verwendung des virtuellen Werkzeugelementes (9), angeordnet im virtuellen Modell (26), abbildbar ist.

4. Anordnung gemäß zumindest einem der vorhergehenden Ansprüche,
wobei die zumindest eine Funktion eine Funktion ist aus der Gruppe bestehend aus Bestimmung von Position, Orientierung, Fertigungsgenauigkeit, Farbwert, Helligkeitswert, Motion-Tracking, Überwachung eines Arbeitsablaufes, Auslösen einer Aktion, Information bzgl. einer Komponente im realen Modell.

5. Anordnung gemäß einem der vorhergehenden Ansprüche, wobei die Visualisierungsvorrichtung (4) eine Informationsaufnahmevorrichtung (28) aufweist,
wobei die Informationsaufnahmevorrichtung (28) eingerichtet ist, zumindest eine Teilinformationen des realen Modells (24) aufzunehmen;
wobei die Visualisierungsvorrichtung (4) eingerichtet ist, eine eigene Position und/oder Orientierung in Relation zum ersten Positionsbestimmungselement (6) zu bestimmen;
wobei die Visualisierungsvorrichtung (4) derart eingerichtet ist, zumindest einen Teil des virtuellen Modells (26) darzustellen; und
wobei der dargestellte Teil des virtuellen Modells (26) von Position und/oder Orientierung des ersten Positionsbestimmungselementes (6) abhängig ist.

6. Anordnung gemäß dem vorhergehenden Anspruch,
wobei das Werkzeugelement (8) ein zweites Positionsbestimmungselement (8) aufweist; und
wobei das zweite Positionsbestimmungselement (8) derart eingerichtet ist, eine Relation des realen Koordinatensystems mit dem ersten Positionsbestimmungselement (6) und/oder mit der Visualisierungsvorrichtung (4) festzulegen.

7. Anordnung gemäß zumindest einem der Ansprüche 5 und 6,
wobei die Visualisierungsvorrichtung (4) zumindest ein Element aufweist aus der Gruppe bestehend aus Speicherelement und Prozessorelement; und
wobei das zumindest ein Element derart eingerichtet ist zumindest einen Teil des virtuellen Modells (26) zur Darstellung bereitzustellen.

8. Anordnung gemäß zumindest einem der Ansprüche 5 bis 7,
wobei die Visualisierungsvorrichtung (4) ein Kommunikationselement (30) aufweist;
wobei unter Verwendung des Kommunikationselementes (30) Daten zu Position, Orientierung und/oder darzustellendem Teil des virtuellen Modells (26) empfangbar sind.

9. Anordnung gemäß zumindest einem der Ansprüche 5 bis 8,
wobei die Visualisierungsvorrichtung (4) eingerichtet ist, zumindest einen Teil des virtuellen Modells (26) derart darzustellen, so dass es zumindest einem Teil des aufgenommenen realen Modells (24) überlagerbar ist.

10. Anordnung gemäß zumindest einem der vorhergehenden Ansprüche,
wobei die Positionsbestimmungsvorrichtung (10) eingerichtet ist, die Position des ersten Positionsbestimmungselementes (6) im virtuellen Modell (26) bereitzustellen.

11. Anordnung gemäß zumindest einem der Ansprüche 5 bis 10,
wobei die Visualisierungsvorrichtung (4) eingerichtet ist, ein Ergebnis einer Funktion im virtuellen Modell (26) sowie das Ergebnis der Funktion im realen Modell (24) darzustellen, insbesondere um die Funktion im realen Modell (24) unter Verwendung des virtuellen Modells (26) zu überprüfen.

12. Verfahren (40) zur Verifikation eines realen Modells einer Flugzeugstruktur unter Verwendung eines virtuellen Modells, aufweisend Bereitstellen einer Anordnung gemäß Anspruch 1; Aufnehmen eines Abbildes des realen Modells durch eine an der Visualisierungsvorrichtung (4) angebrachte Kamera und Darstellen des Abbildes auf der Visualisierungsvorrichtung (4);
Überlagerte Darstellung des realen Modells (24) und des virtuellen Modells (26) durch eine Visualisierungsvorrichtung (4);
wobei eine Funktion des realen Werkzeugelementes (8) mit einer Funktion des virtuellen Werkzeugelements (9) im virtuellen Modell (26) im Wesentlichen identisch ist, Erstellen (50) einer Relation zwischen realem Modell (24) und virtuellem Modell (26), Ermitteln (52) eines Parameters des realen Modells unter Verwendung des realen Werkzeugelementes (8), und Vergleichen des Parameters des realen Modells (24) mit einem Parameter der Funktion im virtuellen Modell (26).

13. Verfahren gemäß Anspruch 12, weiterhin aufweisend
Darstellen (48) eines Gesamtmodells aus zumindest einem Teil des realen Modells (24) und zumindest einem Teil des virtuellen Modells (26);
wobei das virtuelle Modells (26) unter Verwendung der Referenz des realen Modells (24) dargestellt wird, und insbesondere
wobei der zumindest eine Teil des realen Modells (24) und der zumindest eine Teil des virtuellen Modells (26) zumindest teilweise überlagerbar darstellbar sind.

## Claims

1. Arrangement (1) for verifying a real model of an aircraft structure using a virtual model, comprising
a real model (24), comprising a real coordinate system in which a first position-determining element (6) is attached in defined fashion and in which a real tool element (8) is arranged;
a virtual model (26), comprising a virtual coordinate system with a tool element (9) arranged in virtual fashion;
a visualization apparatus (4) for the overlaid presentation of the real model (24) and the virtual model (26);
a camera, which is attached to the visualization apparatus (4) and embodied so as to record an image of the real model and present the latter on the visualization apparatus (4);
a position-determining apparatus (10); wherein the position-determining apparatus (10) is configured to determine and/or, in defined fashion, set the position/orientation of the first position-determining element (6) in the real model (24) ;
wherein a position and/or orientation of the real tool element (8) in the real model (24) is determinable relative to the first position-determining element (6) by means of the position-determining apparatus;
wherein a function of the real tool element (8) is able to be triggered in the real model (24);
a sensor, wherein the function is captured by the sensor;
wherein the function of the real tool element (8) is able to be mapped onto the function of the virtual tool element in the virtual model (24) by the visualization apparatus by virtue of the functions being implemented in identical fashion; and
wherein the function of the real tool element (8) in the real model (24) and the function in the virtual model (26) that is imaged by the visualization apparatus are substantially identical.

2. Arrangement according to Claim 1,
wherein the real function is able to be checked using the imaged function as a result of the identical function in the real model (24) and the imaged function in the virtual model (26).

3. Arrangement according to at least one of the preceding claims,
wherein the position and/or orientation of the real tool element (8) is able to be imaged in the virtual model (24) using the virtual tool element (9) arranged in the virtual model (26).

4. Arrangement according to at least one of the preceding claims,
wherein the at least one function is a function from the group consisting of determining position, orientation, manufacturing accuracy, colour value, brightness value, motion tracking, monitoring of a workflow, triggering an action, information in respect of a component in the real model.

5. Arrangement according to any one of the preceding claims,
wherein the visualization apparatus (4) has an information-recording apparatus (28),
wherein the information-recording apparatus (28) is configured to record at least one partial information item of the real model (24);
wherein the visualization apparatus (4) is configured to determine its own position and/or orientation in relation to the first position-determining element (6);
wherein the visualization apparatus (4) is configured so as to present at least one part of the virtual model (26); and
wherein the illustrated part of the virtual model (26) depends on the position and/or orientation of the first position-determining element (6).

6. Arrangement according to the preceding claim,
wherein the tool element (8) has a second position-determining element (8); and
wherein the second position-determining element (8) is configured so as to set a relationship of the real coordinate system with the first position-determining element (6) and/or with a visualization apparatus (4).

7. Arrangement according to at least one of Claims 5 and 6,
wherein the visualization apparatus (4) has at least one element from the group consisting of memory element and processor element; and
wherein the at least one element is configured so as to provide at least one part of the virtual model (26) for presentation purposes.

8. Arrangement according to at least one of Claims 5 to 7,
wherein the visualization apparatus (4) has a communications element (30);
wherein data in relation to position, orientation and/or part of the virtual model (26) to be presented are receivable using the communications element (30).

9. Arrangement according to at least one of Claims 5 to 8,
wherein the visualization device (4) is configured so as to present at least one part of the virtual model (26) such that it is able to be overlaid on at least one part of the recorded real model (24).

10. Arrangement according to at least one of the preceding claims,
wherein the position-determining apparatus (10) is configured to provide the position of the first position-determining element (6) in the virtual model (26).

11. Arrangement according to at least one of Claims 5 to 10,
wherein the visualization apparatus (4) is configured to present a result of a function in the virtual model (26) and the result of the function in the real model (24), in particular in order to check the function in the real model (24) using the virtual model (26).

12. Method (40) for verifying a real model of an aircraft structure using a virtual model, including
providing an arrangement according to Claim 1;
recording an image of the real model by a camera attached to the visualization apparatus (4) and presenting the image in the visualization apparatus (4);
presenting the real model (24) and the virtual model (26) in superposed fashion by way of a visualization apparatus (4);
wherein a function of the real tool element (8) is substantially identical to a function of the virtual tool element (9) in the virtual model (26),
creating a relationship between the real model (24) and virtual model (26),
establishing (52) a parameter of the real model using the real tool element (8), and
comparing the parameter of the real model (24) to a parameter of the function in the virtual model (26) .

13. Method according to Claim 12, furthermore including
presenting (48) an overall model from at least one part of the real model (24) and at least one part of the virtual model (26);
wherein the virtual model (26) is presented using the reference of the real model (24), and, in particular,
wherein the at least one part of the real model (24) and at least one part of the virtual model (26) are presentable in at least partly overlayable fashion.

## Revendications

1. Arrangement (1) de vérification d'un modèle réel d'une structure d'aéronef en utilisant un modèle virtuel, comprenant
un modèle réel (24) qui possède un système de coordonnées réel dans lequel est monté de manière définie un premier élément de détermination de position (6) et est disposé un élément d'outil réel (8) ;
un modèle virtuel (26) qui possède un système de coordonnées virtuel comprenant un élément d'outil (9) disposé virtuellement ;
un dispositif de visualisation (4) destiné à la représentation superposée du modèle réel (24) et du modèle virtuel (26) ;
une caméra, qui est montée sur le dispositif de visualisation (4) et qui est exécutée pour enregistrer une image du modèle réel et la représenter sur le dispositif de visualisation (4) ;
un dispositif de détermination de position (10) :
le dispositif de détermination de position (10) étant conçu pour déterminer et/ou fixer de manière définie la position/l'orientation du premier élément de détermination de position (6) dans le modèle réel (24) ;
une position et/ou une orientation de l'élément d'outil réel (8) dans le modèle réel (24) pouvant être déterminées au moyen du dispositif de détermination de position par rapport au premier élément de détermination de position (6) ;
une fonction de l'élément d'outil réel (8) dans le modèle réel (24) pouvant être déclenchée ;
un capteur, une détection de la fonction s'effectuant par le capteur ;
la fonction de l'élément d'outil réel (8) pouvant être représentée par le dispositif de visualisation sur la fonction de l'élément d'outil virtuel dans le modèle virtuel (24) du fait que les fonctions sont mises en oeuvre de manière identique ; et
la fonction de l'élément d'outil réel (8) dans le modèle réel (24) et la fonction représentée par le dispositif de visualisation dans le modèle virtuel (26) étant sensiblement identiques.

2. Arrangement selon la revendication 1, la fonction identique dans le modèle réel (24) et la fonction représentée dans le modèle virtuel (26) permettant de contrôler la fonction réelle en utilisant la fonction représentée.

3. Arrangement selon au moins l'une des revendications précédentes, la position et/ou l'orientation de l'élément d'outil réel (8) dans le modèle virtuel (24) pouvant être représentées en utilisant l'élément d'outil virtuel (9) disposé dans le modèle virtuel (26).

4. Arrangement selon au moins l'une des revendications précédentes, l'au moins une fonction étant une fonction du groupe composé de la détermination de la position, de l'orientation, de la précision de fabrication, de la valeur de couleur, de la valeur de luminosité, du suivi de mouvement, de la surveillance du déroulement d'un travail, du déclenchement d'une action, d'informations concernant un composant dans le modèle réel.

5. Arrangement selon l'une des revendications précédentes,
le dispositif de visualisation (4) possédant un dispositif d'enregistrement d'informations (28),
le dispositif d'enregistrement d'informations (28) étant conçu pour enregistrer au moins une information partielle du modèle réel (24) ;
le dispositif de visualisation (4) étant conçu pour déterminer une position et/ou une orientation propres en relation avec le premier élément de détermination de position (6) ;
le dispositif de visualisation (4) étant conçu pour représenter au moins une partie du modèle virtuel (26) ;
et
la partie représentée du modèle virtuel (26) étant dépendante de la position et/ou de l'orientation du premier élément de détermination de position (6).

6. Arrangement selon la revendication précédente, l'élément d'outil (8) possédant un deuxième élément de détermination de position (8) ; et
le deuxième élément de détermination de position (8) étant conçu pour spécifier une relation du système de coordonnées réel avec le premier élément de détermination de position (6) et/ou avec le dispositif de visualisation (4) .

7. Arrangement selon au moins l'une des revendications 5 et 6,
le dispositif de visualisation (4) possédant au moins un élément du groupe composé d'un élément mémoire et d'un élément processeur ; et
l'au moins un élément étant conçu pour fournir au moins une partie du modèle virtuel (26) en vue de la représentation.

8. Arrangement selon au moins l'une des revendications 5 à 7,
le dispositif de visualisation (4) possédant un élément de communication (30) ;
des données à propos de la position, de l'orientation et/ou de la partie à représenter du modèle virtuel (26) pouvant être reçues en utilisant l'élément de communication (30).

9. Arrangement selon au moins l'une des revendications 5 à 8,
le dispositif de visualisation (4) étant conçu pour représenter au moins une partie du modèle virtuel (26) de telle sorte qu'elle peut être superposée à au moins une partie du modèle réel (24) enregistré.

10. Arrangement selon au moins l'une des revendications précédentes, le dispositif de détermination de position (10) étant conçu pour fournir la position du premier élément de détermination de position (6) dans le modèle virtuel (26).

11. Arrangement selon au moins l'une des revendications 5 à 10, le dispositif de visualisation (4) étant conçu pour représenter un résultat d'une fonction dans le modèle virtuel (26) ainsi que le résultat de la fonction dans le modèle réel (24), notamment en vue de contrôler la fonction dans le modèle réel (24) en utilisant le modèle virtuel (26).

12. Procédé (40) de vérification d'un modèle réel d'une structure d'aéronef en utilisant un modèle virtuel, comprenant
fourniture d'un arrangement selon la revendication 1 ; enregistrement d'une image du modèle réel par une caméra montée sur le dispositif de visualisation (4) et représentation de l'image sur le dispositif de visualisation (4) ;
représentation superposée du modèle réel (24) et du modèle virtuel (26) par un dispositif de visualisation (4) ;
une fonction de l'élément d'outil réel (8) étant sensiblement identique à une fonction de l'élément d'outil virtuel (9) dans le modèle virtuel (26), établissement (50) d'une relation entre le modèle réel (24) et le modèle virtuel (26),
détermination (52) d'un paramètre du modèle réel en utilisant l'élément d'outil réel (8) et
comparaison du paramètre du modèle réel (24) avec un paramètre de la fonction dans le modèle virtuel (26).

13. Procédé selon la revendication 12, comprenant en outre
représentation (48) d'un modèle total composé d'au moins une partie du modèle réel (24) et d'au moins une partie du modèle virtuel (26) ;
le modèle virtuel (26) étant représenté en utilisant la référence du modèle réel (24) et notamment
l'au moins une partie du modèle réel (24) et l'au moins une partie du modèle virtuel (26) pouvant être représentées au moins partiellement superposables.
